# EUROPEAN PATENT APPLICATION

(11) **EP 4 529 403 A1**
(43) Date of publication of application: **26.03.2025**
(21) Application number: 24202104.6
(22) Date of filing: 24.09.2024
(51) Int. Cl.: H10K 59/80

(54) **DISPLAY DEVICE**

(30) Priority: 25.09.2023 KR 20230127868
(71) Applicant: Samsung Display Co., Ltd., Gyeonggi-do 17113 (KR)
(72) Inventor: Lee, Hee Young, Yongin-si, Gyeonggi-do (KR); Park, Gil Yeong, Yongin-si, Gyeonggi-do (KR); Han, So Yeon, Yongin-si, Gyeonggi-do (KR); Park, Sang Il, Yongin-si, Gyeonggi-do (KR); An, Sung Guk, Yongin-si, Gyeonggi-do (KR)
(74) Representative: Gulde & Partner

(57) **Abstract**

A display device foldable about a folding axis is provided. The display device includes: a display panel; a cover window on the display panel; and an optical film on the cover window. The optical film has a machine direction and a transverse direction, and the one of the machine direction and the transverse direction of the optical film that has a larger crack strain forms an angle in a range of 15° to 120° with the folding axis.

## Description

### BACKGROUND

### 1. Field

Aspects of embodiments of the present disclosure relate to a display device.

### 2. Description of the Related Art

As the information society develops, the demand for display devices for displaying images has increased and diversified. For example, display devices have been applied to various electronic devices, such as smartphones, digital cameras, laptop computers, navigation devices, and smart televisions.

The display devices may be flat panel display devices, such as liquid crystal display devices, field emission display devices, or light emitting display devices. The light emitting display device may include an organic light emitting display device including organic light emitting elements, an inorganic light emitting display device including inorganic light emitting elements such as inorganic semiconductors, and a micro light emitting display device including micro light emitting elements.

The organic emitting element may include two electrodes opposing each other with a light emitting layer interposed between the two electrodes. The light emitting layer receives electrons and holes from the two electrodes and recombines the electrons and the holes with each other to generate excitons, and emits light when the generated excitons change from an excited state to a ground state.

Because the organic emitting display device including the organic light emitting elements does not require a separate light source, such as a backlight unit, the organic emitting display device has relatively low power consumption, may be configured to be lightweight and thin, and has high-quality quality characteristics, such as a wide viewing angle, high luminance and contrast, and a fast response speed, and accordingly, has attracted attention as a next-generation display device.

### SUMMARY

Aspects and features of the present disclosure provide a display device that can prevent an optical film from being damaged when a display device is folded.

However, aspects and features of the present disclosure are not limited to those set forth herein. The above and other aspects and features of the present disclosure will become more apparent to one of ordinary skill in the art to which the present disclosure pertains by referencing the detailed description of the present disclosure given below.

According to an embodiment of the present disclosure, a display device foldable about a folding axis includes: a display panel; a cover window on the display panel; and an optical film on the cover window. The optical film has a machine direction and a transverse direction, and the one of the machine direction and the transverse direction having a larger crack strain forms an angle in a range of 15° to 120° with the folding axis.

In an embodiment, the crack strain of the optical film in the transverse direction may be greater than the crack strain in the machine direction, and the angle between the transverse direction and the folding axis may be 90°.

In an embodiment, the crack strain of the optical film in the machine direction may be greater than the crack strain in the transverse direction, and the angle between the machine direction and the folding axis may be 90°.

In an embodiment, the optical film may include a base layer, a hard coating layer on the base layer, a low refraction layer on the hard coating layer, and an anti-fingerprint layer on the low refraction layer.

In an embodiment, the low refraction layer may include a resin and a plurality of particles dispersed in the resin.

In an embodiment, a refractive index of the low refraction layer may be in a range of 1.3 to 1.48. The refractive index of a thin film may be measured using an ABBE Refractometer (ATAGO Corporation).

In an embodiment, a thickness of the low refraction layer may be in a range of 10 nm to 200 nm.

In an embodiment, a refractive index of the low refraction layer may be smaller than the refractive index of the hard coating layer.

In an embodiment, the display device may further include a primer layer between the low refraction layer and the anti-fingerprint layer.

In an embodiment, the display device may further include a high refraction layer between the low refraction layer and the hard coating layer.

In an embodiment, a refractive index of the high refraction layer may be in a range of 1.53 to 1.7. The refractive index of a thin film may be measured using an ABBE Refractometer (ATAGO Corporation).

In an embodiment, the optical film may include a base layer, a hard coating layer on the bas layer, and a composite layer on the hard coating layer. The composite layer may include a resin and a plurality of particles and anti-fingerprint material dispersed in the resin.

In an embodiment, the particles may have a hollow, and the anti-fingerprint material may include a fluorine-based additive.

In an embodiment, the one of the machine direction and the transverse direction of the optical film having a larger crack strain may have a crack strain of 2% or more.

According to another embodiment of the present disclosure, a display device foldable about a folding axis includes: a display panel; a cover window on the display panel; and an optical film on the cover window. The optical film has a machine direction and a transverse direction, and an angle between the transverse direction folding axis is in a range of 15° to 120°.

In an embodiment, the crack strain in the transverse direction may be greater than the crack strain in the machine direction.

In an embodiment, an angle between the transverse direction and the folding axis may be 90°.

In an embodiment, the crack strain of the optical film in the transverse direction may be 2% or more.

In an embodiment, the optical film may include a base layer, a hard coating layer on the base layer, a low refraction layer on the hard coating layer, and an anti-fingerprint layer on the low refraction layer.

In an embodiment, the display device may further include a primer layer between the low refraction layer and the anti-fingerprint layer.

A display device, according to an embodiment, may prevent a crack from occurring in an optical film when a display device is folded by arranging the display device to cross a folding axis and a machine direction or a transverse direction of the optical film having large crack strain.

The aspects and features of the present disclosure are not limited to the aforementioned aspects and features, and various other aspects and features are included in the present specification.

### BRIEF DESCRIPTION OF THE DRAWINGS

The above and other aspects and features of the present disclosure will become more apparent by describing, in detail, embodiments thereof with reference to the attached drawings, in which:
FIG. 1 is a schematic plan view of an electronic device according to an embodiment;
FIG. 2 is a perspective view of a foldable display device in a folded state according to an embodiment;
FIG. 3 is a perspective view of the foldable display device shown in FIG. 2 in an unfolded state;
FIG. 4 is a perspective view of a display device included in the electronic device shown in FIG. 1 according to an embodiment;
FIG. 5 is a cross-sectional view of the display device shown in FIG. 4;
FIG. 6 is a plan view of a display layer of the display device according to an embodiment;
FIG. 7 is a plan view illustrating a touch sensing layer of the display device according to an embodiment;
FIG. 8 is a plan view illustrating an arrangement of emission areas in a display area of the display device according to an embodiment;
FIG. 9 is a cross-sectional view taken along the line X-X' in FIG. 8;
FIG. 10 is a schematic cross-sectional view of an optical film of the display device according to an embodiment;
FIG. 11 is a plan view illustrating a direction transverse to a machine direction of an optical film according to an embodiment;
FIG. 12 is a plan view illustrating a direction transverse to a machine direction of a folding axis and an optical film of a display device;
FIG. 13 is a plan view illustrating a direction transverse to a folding axis and an optical film of a display device;
FIG. 14 is a plan view illustrating the machine direction of a folding axis and an optical film of a display device;
FIG. 15 is a cross-sectional view of an optical film according to another embodiment;
FIG. 16 is a cross-sectional view of an optical film according to another embodiment;
FIG. 17 is a cross-sectional view of an optical film according to another embodiment.

### DETAILED DESCRIPTION

The present disclosure will now be described more fully hereinafter with reference to the accompanying drawings, in which embodiments of the present disclosure are shown. The present disclosure may, however, be embodied in different forms and should not be construed as limited to the embodiments set forth herein. Rather, these embodiments are provided so that this disclosure will be thorough and complete, and will filly convey the scope of the present disclosure to those skilled in the art.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. For example, the expression "at least one of a, b, or c" indicates only a, only b, only c, both a and b, both a and c, both b and c, all of a, b, and c, or variations thereof. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Each of the features of the various embodiments of the present disclosure may be combined or combined with each other, in part or in whole, and technically various interlocking and driving are possible. Each embodiment may be implemented independently of each other or may be implemented together in an association.

Hereinafter, embodiments of the present disclosure will be described with reference to the accompanying drawings.

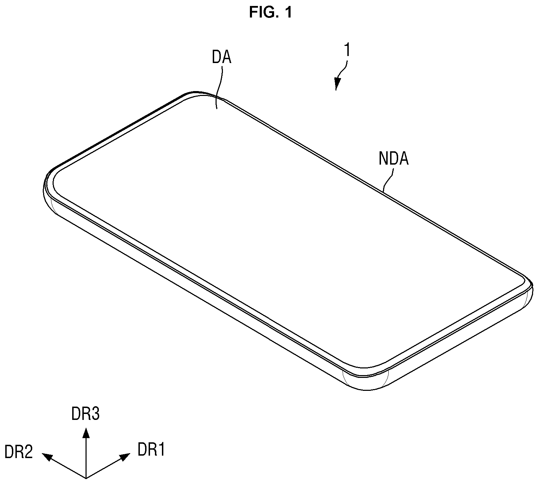

FIG. 1 is a schematic plan view of an electronic device according to an embodiment.

Referring to FIG. 1, an electronic device 1 displays a moving image and/or a still image. The electronic device 1 may refer to all electronic devices that provide display screens. For example, televisions, laptop computers, monitors, billboards, Internet of Things (IoT) devices, mobile phones, smartphones, tablet personal computers (PCs), electronic watches, smart watches, watch phones, head mounted displays, mobile communication terminals, electronic notebooks, electronic books, portable multimedia players (PMPs), navigation devices, game machines, digital cameras, camcorders, and the like, which provide (or include) display screens may be included in the electronic device 1.

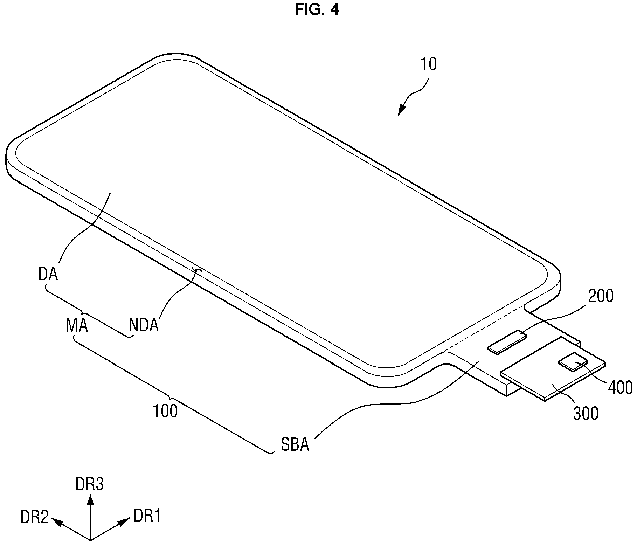

The electronic device 1 may include a display device 10 (see, e.g., FIG. 4) providing a display screen. Examples of the display device may include an inorganic light emitting diode display device, an organic light emitting display device, a quantum dot light emitting display device, a plasma display device, a field emission display device, and the like. Hereinafter, an embodiment in which an organic light emitting diode display device is used as an example of the display device will be described by way of example, but the present disclosure is not limited thereto, and the same technical scope may be applied to other display devices if applicable.

A shape of the electronic device 1 may be variously modified. For example, the electronic device 1 may have a shape, such as a rectangular shape with a width greater than a length, a rectangular shape with a length greater than a width, a square shape, a quadrangular shape with rounded corners (e.g., vertices), other polygonal shapes, or a circular shape. A shape of a display area DA of the electronic device 1 may be similar to an overall shape of the electronic device 1. In FIG. 1, the electronic device 1 having a rectangular shape with a greater length in a second direction DR2 than in the first direction DR1 has been illustrated.

The electronic device 1 may have the display area DA and a non-display area NDA. The display area DA is an area at where an image may be displayed, and the non-display area NDA is an area at where an image is not displayed. The display area DA may be referred to as an active area, and the non-display area NDA may be referred to as a non-active area. The display area DA may occupy substantially the center of the electronic device 1.

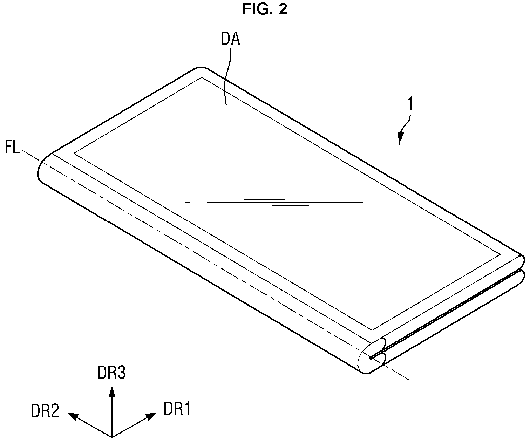

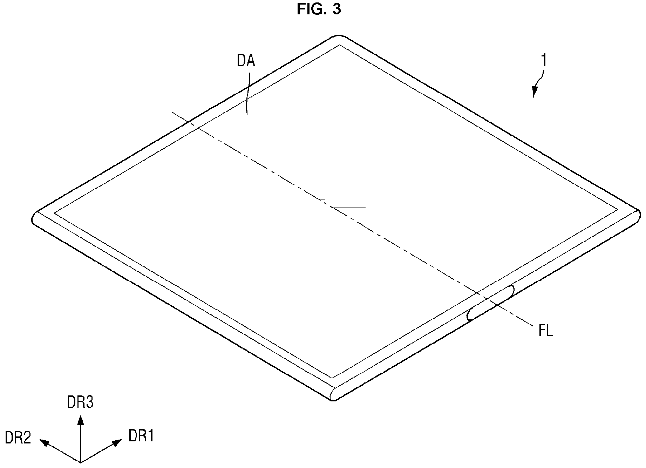

FIG. 2 is a perspective view of a foldable display device according to an embodiment in a folded state. FIG. 3 is a perspective view of the foldable display device shown in FIG. 2 in an unfolded state.

Referring to FIGS. 2 and 3, the electronic device 1, according to an embodiment, may be a foldable display device. The foldable electronic device 1 may be folded about a folding axis FL. The display area DA may be disposed on an outer side (or surface) and/or an inner side of the foldable electronic device 1. In an embodiment, as has been illustrated in FIGS. 2 and 3, the display area DA is disposed on each of the inner side and the outer side of the foldable electronic device 1.

The display area DA may be disposed on the outer side of the electronic device 1. An outer side surface of the folded electronic device 1 may include the display area DA, and an inner side surface of the unfolded electronic device 1 may include the display area DA.

FIG. 4 is a perspective view of a display device included in the electronic device according to an embodiment.

Referring to FIG. 4, the electronic device 1, according to an embodiment, may include a display device 10. The display device 10 may provide (or may include) a screen for the electronic device 1. The display device 10 may have a shape similar to that of the electronic device 1 in a plan view. For example, the display device 10 may have a shape similar to a rectangular shape having shorter sides in a first direction DR1 and longer sides in the second direction DR2. A corner at where the shorter side in the first direction DR1 and the longer side in the second direction DR2 meet may be rounded with a curvature but is not limited thereto and may be right-angled. The shape of the display device 10, in a plan view, is not limited to the rectangular shape and may be a shape similar to other polygonal shapes, a circular shape, or an elliptical shape.

The display device 10 may include a display panel 100, a display driver 200, a circuit board 300, and a touch driver 400.

The display panel 100 may have a main area MA and a sub-area SBA.

The main area MA may have (or may include) a display area DA including pixels for displaying an image and a non-display area NDA disposed around (e.g., extending around a periphery of) the display area DA. The display area DA may emit light from a plurality of emission areas or a plurality of open areas. For example, the display panel 100 may include pixel circuits including switching elements, a pixel defining film defining the emission areas or the open areas, and self-light emitting elements.

For example, the self-light emitting element may include at least one of an organic light emitting diode (LED) including an organic light emitting layer, a quantum dot LED including a quantum dot light emitting layer, an inorganic LED including an inorganic semiconductor, and a micro LED, but it is not limited thereto.

The non-display area NDA may be an area outside the display area DA. The non-display area NDA may be defined as an edge area of the main area MA of the display panel 100. The non-display area NDA may include a gate driver for supplying gate signals to gate lines and fan-out lines for connecting the display driver 200 and the display area DA (e.g., the pixel circuits in the display area DA) to each other.

The sub-area SBA may be an area extending from one side of the main area MA. The sub-area SBA may include a flexible material that may be bent, folded, and rolled. For example, when the sub-area SBA is bent, the sub-area SBA may overlap the main area MA in a thickness direction (e.g., a third direction DR3). The sub-area SBA may include the display driver 200 and pad parts connected to the circuit board 300. In another embodiment, the sub-area SBA may be omitted, and the display driver 200 and the pad parts may be disposed in the non-display area NDA.

The display driver 200 may output signals and voltages for driving the display panel 100. The display driver 200 may supply data voltages to data lines. The display driver 200 may supply source voltages to power lines and supply gate control signals to the gate driver. The display driver 200 may be formed as an integrated circuit (IC) and mounted on the display panel 100 in a chip on glass (COG) manner, a chip on plastic (COP) manner, or an ultrasonic bonding manner. As an example, the display driver 200 may be disposed in the sub-area SBA and may overlap the main area MA in the thickness direction by bending of the sub-area SBA. In another embodiment, the display driver 200 may be mounted on the circuit board 300.

The circuit board 300 may be attached onto the pad parts of the display panel 100 by using an anisotropic conductive film (ACF). Lead lines of the circuit board 300 may be electrically connected to the pad parts of the display panel 100. The circuit board 300 may be a flexible printed circuit board, a printed circuit board, or a flexible film, such as a chip on film.

The touch driver 400 may be mounted on the circuit board 300. The touch driver 400 may be connected to a touch sensing unit of the display panel 100. The touch driver 400 may supply touch driving signals to a plurality of touch electrodes of the touch sensing unit and may sense changes in capacitance between the plurality of touch electrodes. For example, the touch driving signal may be a pulse signal having a predetermined frequency. The touch driver 400 may decide whether or not an input has occurred and may calculate input coordinates based on the changes in capacitance between the plurality of touch electrodes. The touch driver 400 may be formed as an integrated circuit (IC).

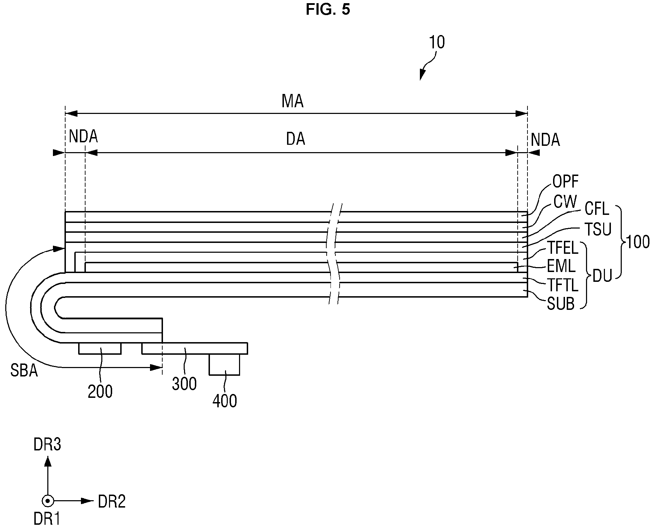

FIG. 5 is a cross-sectional view of the display device shown in FIG. 4.

Referring to FIG. 5, the display panel 100 may include a display layer DU, a touch sensing layer TSU, a color filter layer CFL, a cover window CW, and an optical film OPF. The display layer DU may include a substrate SUB, a thin film transistor layer TFTL, a light emitting element layer EML, and an encapsulation layer TFEL.

The substrate SUB may be a base substrate or a base member. The substrate SUB may be a flexible substrate that may be bent, folded, and rolled. For example, the substrate SUB may include a polymer resin, such as polyimide (PI), but is not limited thereto. In another embodiment, the substrate SUB may include a glass material or a metal material.

The thin film transistor layer TFTL may be disposed on the substrate SUB. The thin film transistor layer TFTL may include a plurality of thin film transistors constituting pixel circuits of pixels. The thin film transistor layer TFTL may further include gate lines, data lines, power lines, gate control lines, fan-out lines connecting the display driver 200 and the data lines to each other, and lead lines connecting the display driver 200 and the pad parts to each other. Each of the thin film transistors may include a semiconductor region, a source electrode, a drain electrode, and a gate electrode. For example, when a gate driver is formed on one side of the non-display area NDA of the display panel 100, the gate driver may include thin film transistors.

The thin film transistor layer TFTL may be disposed in the display area DA, the non-display area NDA, and the sub-area SBA. The thin film transistors of each of the pixels, the gate lines, the data lines, and the power lines of the thin film transistor layer TFTL may be disposed in the display area DA. The gate control lines and the fan-out lines of the thin film transistor layer TFTL may be disposed in the non-display area NDA. The lead lines of the thin film transistor layer TFTL may be disposed in the sub-area SBA.

The light emitting element layer EML may be disposed on the thin film transistor layer TFTL. The light emitting element layer EML may include a plurality of light emitting elements each including a first electrode, a second electrode, and a light emitting layer to emit light and a pixel defining film defining the pixels. The plurality of light emitting elements of the light emitting element layer EML may be disposed in the display area DA.

In an embodiment, the light emitting layer may be an organic light emitting layer including an organic material. The light emitting layer may include a hole transporting layer, an organic light emitting layer, and an electron transporting layer. When the first electrode receives a voltage through the thin film transistor of the thin film transistor layer TFTL and the second electrode receives a cathode voltage, holes and electrons may move to the organic light emitting layer through (or from) the hole transporting layer and the electron transporting layer, respectively, and may be combined with each other in the organic light emitting layer to emit light.

In another embodiment, the light emitting element may include a quantum dot light emitting diode including a quantum dot light emitting layer, an inorganic light emitting diode including an inorganic semiconductor, or a micro light emitting diode.

The encapsulation layer TFEL may cover an upper surface and side surfaces of the light emitting element layer EML and may protect the light emitting element layer EML. The encapsulation layer TFEL may include at least one inorganic film and at least one organic film for encapsulating the light emitting element layer EML.

The touch sensing layer TSU may be disposed on the encapsulation layer TFEL. The touch sensing layer TSU may include a plurality of touch electrodes for sensing a user's touch in a capacitance manner and touch lines connecting the plurality of touch electrodes and the touch driver 400 to each other. For example, the touch sensing layer TSU may sense the user's touch in a mutual capacitance manner or a self-capacitance manner.

In another embodiment, the touch sensing layer TSU may be disposed on a separate substrate disposed on the display layer DU. In such an embodiment, the substrate supporting the touch sensing layer TSU may be a base member encapsulating the display layer DU.

The plurality of touch electrodes of the touch sensing layer TSU may be disposed in a touch sensor area overlapping the display area DA. The touch lines of the touch sensing layer TSU may be disposed in a touch peripheral area overlapping the non-display area NDA.

The color filter layer CFL may be disposed on the touch sensing layer TSU. The color filter layer CFL may include a plurality of color filters each corresponding to the plurality of emission areas. Each of the color filters may selectively transmit light of a specific wavelength therethrough and may block or absorb light of other wavelengths. The color filter layer CFL may absorb some light introduced from the outside of the display device 10 to reduce reflected external light. Accordingly, the color filter layer CFL may prevent distortion of colors due to external light reflection.

Because the color filter layer CFL is directly disposed on the touch sensing layer TSU, the display device 10 may omit a separate substrate for the color filter layer CFL. Accordingly, a thickness of the display device 10 may be relatively small.

The cover window CW may be disposed on the color filter layer CFL. The cover window CW may protect the display panel 100. The cover window CW may be made of a transparent material. The cover window CW may include, for example, glass or plastic.

When the cover window CW includes glass, the glass may be ultra-thin glass (UTG) or thin glass. The ultra-thin glass may be strengthened to have a stress profile (e.g., a predetermined stress profile) therein. The strengthened ultra-thin glass is more resistant to the occurrence of cracks, propagation of cracks, damage, and the like due to external shock than before it is strengthened. The ultra-thin glass strengthened through a strengthening process may have various stresses at each area.

When the glass is the ultra-thin glass or the thin glass, the glass may have flexible characteristics to be bent, folded, or rolled. A thickness of the glass may be, for example, in the range of 10 µm to 300 µm, and in one embodiment, glass having a thickness in a range of 10 µm to 100 µm, or about 50 µm, may be used. The glass of the cover window CW may include soda lime glass, alkali aluminosilicate glass, borosilicate glass, or lithium aluminosilicate glass. The glass of the cover window CW may include chemically strengthened or thermally strengthened glass to have high strength. Chemical strengthening may be achieved through an ion exchange treatment process in an alkali salt. The ion exchange treatment process may be performed twice or more. In addition, the cover window CW may be formed by coating both surfaces of a polymer film with thin glass.

The optical film OPF may be disposed on the cover window CW. The optical film OPF may protect the cover window CW, reduce reflection of external light, and prevent a fingerprint from remaining. A detailed description of the optical film OPF will be provided later.

A barrier layer may be disposed below the display panel 100, and a plate may be disposed below the barrier layer.

The barrier layer may include a polymer film. The barrier layer may include, for example, polyimide (PI), polyethylene terephthalate (PET), polycarbonate (PC), polyethylene (PE), polypropylene (PP), polysulfone (PSF), polymethyl methacrylate (PMMA), triacetyl cellulose (TAC), a cycloolefin polymer (COP), and the like. The barrier layer may include a functional layer on at least one surface thereof. The functional layer may include, for example, a light absorbing layer. The light absorbing layer may include a light absorbing material, such as a black pigment or dye. The light absorbing layer may be made of black ink and may be formed on the polymer film by a coating or printing method.

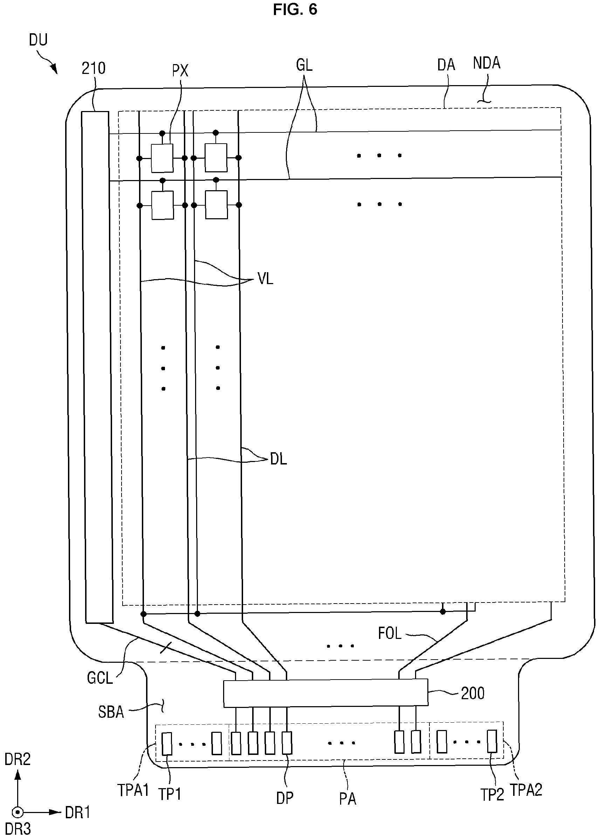

FIG. 6 is a plan view illustrating a display layer of the display device according to an embodiment.

Referring to FIG. 6, the display layer DU may have a display area DA and a non-display area NDA.

The display area DA may be disposed at the center of the display panel 100. A plurality of pixels PX, a plurality of gate lines GL, a plurality of data lines DL, and a plurality of power lines VL may be disposed in the display area DA. Each of the plurality of pixels PX may be defined as a minimum light emitting unit.

The plurality of gate lines GL may supply gate signals received from a gate driver 210 to the plurality of pixels PX. The plurality of gate lines GL may extend in the first direction DR1 and may be spaced apart from each other in the second direction DR2 crossing the first direction DR1.

The plurality of data lines DL may supply data voltages received from the display driver 200 to the plurality of pixels PX. The plurality of data lines DL may extend in the second direction DR2 and may be spaced apart from each other in the first direction DR1.

The plurality of power lines VL may supply source voltages received from the display driver 200 to the plurality of pixels PX. The source voltage may be at least one of a driving voltage, an initialization voltage, a reference voltage, and a low potential voltage. The plurality of power lines VL may extend in the second direction DR2 and may be spaced apart from each other in the first direction DR1.

The non-display areas NDA may surround (e.g., may surround a periphery of) the display area DA. The gate driver 210, fan-out lines FOL, and gate control lines GCL may be disposed in the non-display area NDA. The gate driver 210 may generate a plurality of gate signals based on gate control signals and may sequentially supply the plurality of gate signals to the plurality of gate lines GL according to a set (or predetermined) order.

The fan-out lines FOL may extend from the display driver 200 to the display area DA. The fan-out lines FOL may supply the data voltages received from the display driver 200 to the plurality of data lines DL.

The gate control lines GCL may extend from the display driver 200 to the gate driver 210. The gate control lines GCL may supply the gate control signals received from the display driver 200 to the gate driver 210.

The display driver 200, a pad area PA, and first and second touch pad areas TPA1 and TPA2 may be arranged in the sub-area SBA.

The display driver 200 may output signals and voltages for driving the display panel 100 to the fan-out lines FOL. The display driver 200 may supply the data voltages to the data lines DL through the fan-out lines FOL. The data voltages may be supplied to the plurality of pixels PX and may control luminance of the plurality of pixels PX. The display driver 200 may supply the gate control signals to the gate driver 210 through the gate control lines GCL.

The pad area PA, the first touch pad area TPA1, and the second touch pad area TPA2 may be disposed at an edge of the sub-area SBA. The pad area PA, the first touch pad area TPA1, and the second touch pad area TPA2 may be electrically connected to the circuit board 300 by using a material, such as an anisotropic conductive film or a self-assembly anisotropic conductive paste (SAP).

The pad area PA may include a plurality of display pad parts DP. The plurality of display pad parts DP may be connected to a graphic system through the circuit board 300. The plurality of display pad parts DP may be connected to the circuit board 300 to receive digital video data and may supply the digital video data to the display driver 200.

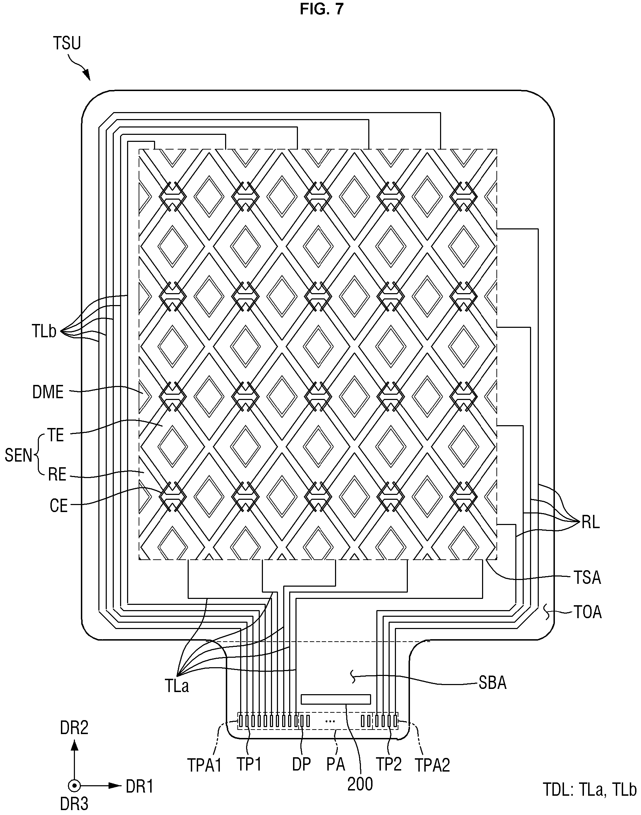

FIG. 7 is a plan view illustrating a touch sensing layer of the display device according to an embodiment.

Referring to FIG. 7, the touch sensing layer TSU may include a touch sensor area TSA for sensing a user's touch and a touch peripheral area TOA disposed around the touch sensor area TSA. The touch area TSA may be disposed in (or may overlap) the display area DA of the display device 10, and the touch peripheral area TOA may be disposed in (or may overlap) the non-display area NDA of the display device 10.

The touch sensor area TSA may include a plurality of touch electrodes SEN and a plurality of dummy electrodes DME. The plurality of touch electrodes SEN may form mutual capacitance or self-capacitance to sense a touch of an object or a person. The plurality of touch electrodes SEN may include a plurality of driving electrodes TE, a plurality of sensing electrodes RE, and bridge electrodes CE.

The plurality of driving electrodes TE may be arranged in the first direction DR1 and the second direction DR2. The plurality of driving electrodes TE may be spaced apart from each other in the first direction DR1 and the second direction DR2. The driving electrodes TE adjacent to each other in the second direction DR2 may be electrically connected to each other through a bridge electrode CE.

The plurality of driving electrodes TE may be connected to first touch pad parts TP1 through driving lines TL. The driving lines TL may include lower driving lines TLa and upper driving lines TLb. For example, the driving electrodes TE disposed on the lower side of the touch sensor area TSA may be connected to the first touch pad parts TP1 through the lower driving lines TLa, and the driving electrodes TE disposed on the upper side of the touch sensor area TSA may be connected to the first touch pad parts TP1 through the upper driving lines TLb. The lower driving lines TLa may extend to the first touch pad parts TP1 via the lower side of the touch peripheral area TOA. The upper driving lines TLb may extend to the first touch pad parts TP1 via the upper, left, and lower sides of the touch peripheral area TOA. The first touch pad parts TP1 may be connected to the touch driver 400 through the circuit board 300.

The bridge electrode CE may be bent at least once. For example, the bridge electrode CE may have a clamp shape ("<" or ">"), but a shape of the bridge electrode CE in a plan view is not limited thereto. The drive electrodes TE adjacent to each other in the second direction DR2 may be connected to each other by a plurality of bridge electrodes CE, and even if one of the bridge electrodes CE is disconnected, the driving electrodes TE may be stably connected to each other through the other bridge electrodes CE. The driving electrodes TE adjacent to each other may be connected to each other by two bridge electrodes CE, but the number of bridge electrodes CE connecting adjacent driving electrodes TE to each other is not limited thereto.

The bridge electrodes CE may be disposed at a different layer from the plurality of driving electrodes TE and the plurality of sensing electrodes RE. The sensing electrodes RE adjacent to each other in the first direction DR1 may be electrically connected to each other through connection parts disposed on the same layer as the plurality of driving electrodes TE or the plurality of sensing electrodes RE, and the driving electrodes TE adjacent to each other in the second direction DR2 may be electrically connected to each other through the bridge electrodes CE disposed on a different layer as the plurality of driving electrodes TE or the plurality of sensing electrodes RE. Accordingly, even though the bridge electrodes CE overlap the plurality of sensing electrodes RE in a thickness (or Z-axis) direction, the plurality of driving electrodes TE and the plurality of sensing electrodes RE may be insulated from each other. Mutual capacitance may be formed between the driving electrodes TE and the sensing electrodes RE.

The plurality of sensing electrodes RE may extend in the first direction DR1 and may be spaced apart from each other in the second direction DR2. The plurality of sensing electrodes RE may be arranged in the first direction DR1 and the second direction DR2, and the plurality of sensing electrodes RE adjacent to each other in the first direction DR1 may be electrically connected to each other through the connection parts.

The plurality of sensing electrodes RE may be connected to second touch pad parts TP2 through sensing lines RL. For example, the sensing electrodes RE disposed on the right side of the touch sensor area TSA may be connected to the second touch pad parts TP2 through the sensing lines RL. The sensing lines RL may extend to the second touch pad parts TP2 via the right side and the lower side of the touch peripheral area TOA. The second touch pad parts TP2 may be connected to the touch driver 400 through the circuit board 300.

Each of the plurality of dummy electrodes DME may be surrounded by the driving electrode TE or the sensing electrode RE. Each of the plurality of dummy electrodes DME may be spaced apart and insulated from the driving electrode TE or the sensing electrode RE. Accordingly, the dummy electrodes DME may electrically float.

The pad area PA, the first touch pad area TPA1, and the second touch pad area TPA2 may be disposed at the edge of the sub-area SBA. The pad area PA, the first touch pad area TPA1, and the second touch pad area TPA2 may be electrically connected to the circuit board 300 by using a low-resistance and high-reliability material, such as an anisotropic conductive film or a self-assembly anisotropic conductive paste (SAP).

The first touch pad area TPA1 may be disposed on one side of the pad area PA and may include a plurality of first touch pad parts TP1. The plurality of first touch pad parts TP1 may be electrically connected to the touch driver 400 disposed on the circuit board 300. The plurality of first touch pad parts TP1 may supply touch driving signals to the plurality of driving electrodes TE through a plurality of driving lines TL.

The second touch pad area TPA2 may be disposed on the other side of the pad area PA and may include a plurality of second touch pad parts TP2. The plurality of second touch pad parts TP2 may be electrically connected to the touch driver 400 disposed on the circuit board 300. The touch driver 400 may receive touch sensing signals through a plurality of sensing lines RL connected to the plurality of second touch pad parts TP2 and may sense changes in mutual capacitance between the driving electrodes TE and the sensing electrodes RE.

In another embodiment, the touch driver 400 may supply a touch driving signal to each of the plurality of driving electrodes TE and the plurality of sensing electrodes RE and may receive a touch sensing signal from each of the plurality of driving electrodes TE and the plurality of sensing electrodes RE. The touch driver 400 may sense a change in a charge of each of the plurality of driving electrodes TE and the plurality of sensing electrodes RE based on the touch sensing signal.

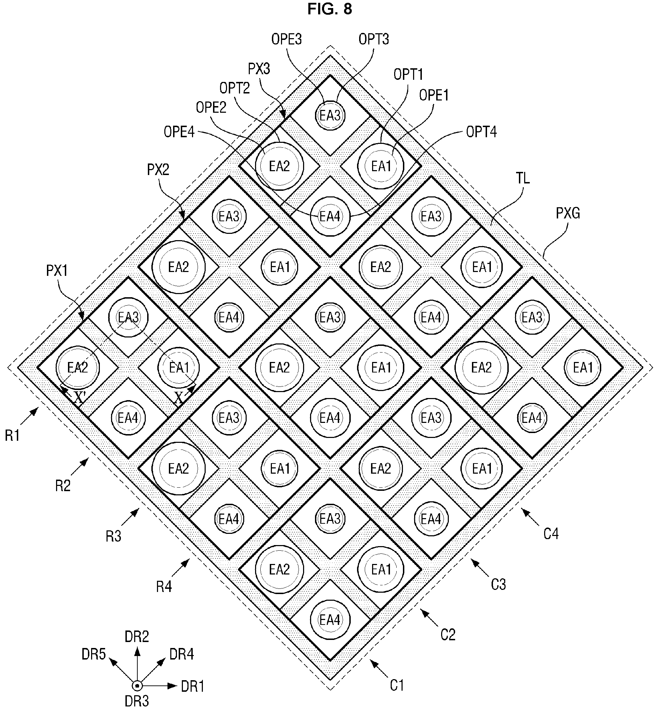

FIG. 8 is a plan view illustrating an arrangement of emission areas in a display area of the display device according to an embodiment.

Referring to FIG. 8, the display device 10 may include a plurality of pixels PX1, PX2, and PX3 disposed in the display area DA and emission areas EA1, EA2, EA3, and EA4 and a non-emission area NEA disposed in each of the pixels PX1, PX2, PX3, and PX4. The plurality of pixels PX1, PX2, and PX3 may be arranged in a fourth direction DR4 and a fifth direction DR5 between the first direction DR1 and the second direction DR2. First pixels PX1, second pixels PX2, and third pixels PX3 may be alternately arranged along the fourth direction DR4 and the fifth direction DR5. For example, the second pixels PX2 and the third pixels PX3 may be arranged along the fourth direction DR4 and the fifth direction DR5 based on the first pixel PX1. The plurality of pixels PX1, PX2, and PX3 may be disposed in a PenTile^{™} (a registered trademark of Samsung Display Co., Ltd.) type, for example, a Diamond Pixel^{™} type, in the display area DA. However, a layout or an arrangement of the pixels PX1, PX2, and PX3 is not limited to that illustrated in FIG. 8. In some embodiments, the plurality of pixels PX1, PX2, and PX3 may be arranged in a linear or island-shaped pattern.

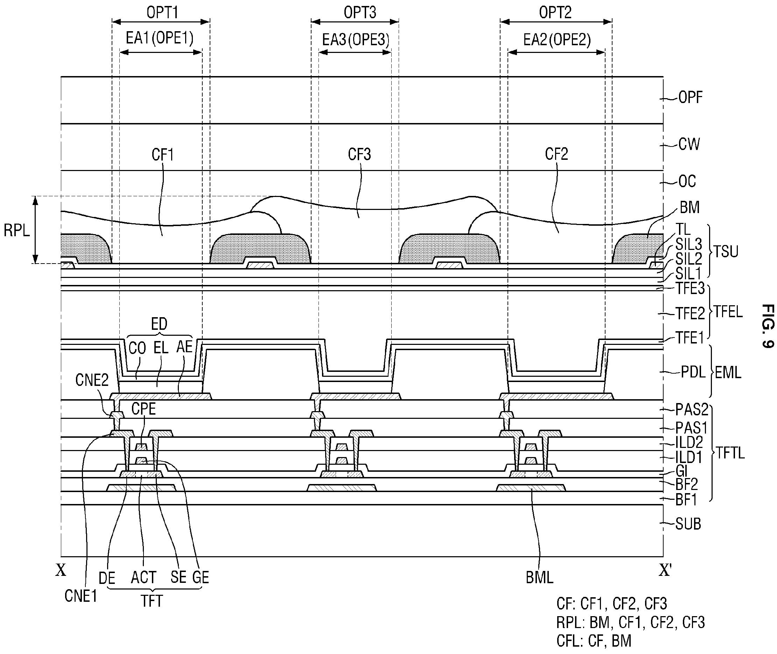

The emission areas EA1, EA2, EA3, and EA4 of each of the pixels PX1, PX2, and PX3 may include a first emission area EA1, a second emission area EA2, and a third emission area EA3 and a fourth emission area EA4 that emit light of different colors. Different from the first emission area EA1 and the second emission area EA2, the third emission area EA3 and the fourth emission area EA4 may emit light of the same color. The first to fourth emission areas EA1, EA2, EA3, and EA4 may emit red, blue, or green light, respectively, and colors of light emitted from the respective emission areas EA1, EA2, EA3, and EA4 may be different depending on a type of light emitting element ED (see, e.g., FIG. 9) disposed in a light emitting element layer EML, to be described later. In an embodiment, the first emission area EA1 may emit first light, which is the red light, the second emission area EA2 may emit second light, which is the blue light, and the third emission area EA3 and the fourth emission area EA4 may emit third light, which is the green light. However, the present disclosure is not limited thereto.

A plurality of emission areas EA1, EA2, EA3, and EA4 may be disposed in a PenTile^{™} type, for example, a Diamond Pixel^{™} type. For example, within each of the pixels PX1, PX2, and PX3, the first emission area EA1 and the second emission area EA2 may be disposed to be spaced apart from each other in the first direction DR1, and the third emission area EA3 and the fourth emission area EA4 may be disposed to be spaced apart from each other in the second direction DR2. The first emission area EA1 may be disposed to be spaced apart from the third emission area EA3 in the fifth direction DR5 and may be disposed to be spaced apart from the fourth emission area EA4 in the fourth direction DR4. The second emission area EA2 may be disposed to be spaced apart from the third emission area EA3 in the fourth direction DR4 and may be disposed to be spaced apart from the fourth emission area EA4 in the fifth direction DR5.

In the plurality of pixels PX1, PX2, and PX3, a plurality of first to fourth emission areas EA1, EA2, EA3, and EA4 may be alternately disposed in the fourth direction DR4 or the fifth direction DR5. For example, the plurality of emission areas EA1, EA2, EA3, and EA4 may be disposed in rows R1, R2, R3, and R4 arranged along the fourth direction DR4 and columns C1, C2, C3, and C4 arranged along the fifth direction DR5. The second emission areas EA2 and the third emission areas EA3 may be alternately disposed along the fourth direction DR4 in a first row R1 and a third row R3. The first emission areas EA1 and the fourth emission areas EA4 may be alternately disposed along the fourth direction DR4 in a second row R2 and a fourth row R4. The second emission areas EA2 and the fourth emission areas EA4 may be alternately disposed along the fifth direction DR5 in a first column C1 and a third column C3. The first emission areas EA1 and the third emission areas EA3 may be alternately disposed along the fourth direction DR4 in a second column C2 and a fourth column C4.

In another embodiment, the plurality of emission areas EA1, EA2, EA3, and EA4 may be arranged along the first direction DR1 or the second direction DR2. The first emission areas EA1 and the second emission areas EA2 may be alternately disposed along the first direction DR1 and the second direction DR2. The third emission areas EA3 and the fourth emission areas EA4 may be alternately disposed along the first direction DR1 and the second direction DR2.

The first to fourth emission areas EA1, EA2, EA3, and EA4 may be defined, respectively, by a plurality of openings OPE1, OPE2, OPE3, and OPE4 formed in a pixel defining film PDL (see, e.g., FIG. 9) of a light emitting element layer EML, to be described later. For example, the first emission area EA1 may be defined by a first opening OPE1 in the pixel defining film, the second emission area EA2 may be defined by a second opening OPE2 in the pixel defining film, the third emission area EA3 may be defined by a third opening OPE3 in the pixel defining film, and the fourth emission area EA4 may be defined by a fourth opening OPE4 in the pixel defining film.

In an embodiment, areas or sizes of the first to fourth emission areas EA1, EA2, EA3, and EA4 may be different from each other. In the embodiment shown in FIG. 8, an area of the second emission area EA2 may be greater than areas of the first emission area EA1, the third emission area EA3, and the fourth emission area EA4, and an area of the first emission area EA1 may be greater than areas of the third emission area EA3 and the fourth emission area EA4. The areas of the emission areas EA1, EA2, EA3, and EA4 may be changed depending on sizes of the openings OPE1, OPE2, OPE3, and OPE4 formed in the pixel defining film. Intensities of the light emitted from the emission areas EA1, EA2, EA3, and EA4 may be changed depending on the areas of the emission areas EA1, EA2, EA3, and EA4, and a color feeling (or color mixture) of an image displayed on the display device 10 or the electronic device 1 may be controlled by adjusting the areas of the emission area EA1, EA2, EA3, and EA4. The embodiment shown in FIG. 8 includes the second emission area EA2 having the greatest area, but the present disclosure is not limited thereto. The areas of the emission areas EA1, EA2, EA3, and EA4 may be suitably adjusted according to a color feeling of the image displayed by the display device 10 and the electronic device 1. In addition, the areas of the emission areas EA1, EA2, EA3, and EA4 may be related to light efficiency, lifespan of light emitting elements ED, and the like, and may have a trade-off relationship with external light reflection. The areas of the emission areas EA1, EA2, EA3, and EA4 may be adjusted in consideration of the above factors.

In addition, an embodiment has illustrated and described in which each of the plurality of openings OPE1, OPE2, OPE3, and OPE4 and a plurality of holes OPT1, OPT2, OPT3, and OPT4 has a circular shape, but the present disclosure is not limited thereto. In other embodiments, each of the plurality of openings OPE1, OPE2, OPE3, and OPE4 and the plurality of holes OPT1, OPT2, OPT3, and OPT4 may have various shapes, such as an elliptical shape or polygonal shape of which edges are formed as curved lines.

Each of the plurality of pixels PX1, PX2, and PX3 may include the first to fourth emission areas EA1, EA2, EA3, and EA4 disposed adjacent to each other to express a white gradation. However, the present disclosure is not limited thereto, and a combination of the emission areas EA1, EA2, EA3, and EA4 constituting one pixel group may be variously modified depending on an arrangement of the emission areas EA1, EA2, EA3, and EA4, colors of the light emitted by the emission areas EA1, EA2, EA3, and EA4, and the like.

The non-emission area NEA may be an area other than the emission areas EA1, EA2, EA3, and EA4. The non-emission area NEA may be disposed between the emission areas EA1, EA2, EA3, and EA4. The non-emission area NEA may overlap the pixel defining film. For example, the non-emission area NEA may be the same as an area of the pixel defining film.

The display device 10 may include a plurality of color filters CF1 and CF2 and a color pattern CP disposed on the emission areas EA1, EA2, EA3, and EA4. Each of the plurality of color filters CF1 and CF2 and the color pattern CP may be disposed to correspond to the emission areas EA1, EA2, EA3, and EA4. For example, the color filters CF1 and CF2 and the color pattern CP may be disposed to overlap the emission areas EA1, EA2, EA3, and EA4, the openings OPE1, OPE2, OPE3, and OPE4, or the plurality of holes OPT1, OPT2, and OPT3, and OPT4. The plurality of holes OPT1, OPT2, OPT3, and OPT4 may be formed to overlap the openings OPE1, OPE2, OPE3, and OPE4 and may form light emitting areas through which the light emitted from the emission areas EA1, EA2, EA3, and EA4 is emitted. Each of the color filters CF1 and CF2 and the color pattern CP may have a greater area than each of the holes OPT1, OPT2, OPT3, and OPT4 and the openings OPE1, OPE2, OPE3, and OPE4 and may completely cover each of the light emitting areas formed by the holes OPT1, OPT2, OPT3, and OPT4.

The color filters CF1 and CF2 and the color pattern CP may be disposed to each correspond to different emission areas EA1, EA2, EA3, and EA4. The color filters CF1 and CF2 may include a first color filter CF1 and a second color filter CF2. The color filters CF1 and CF2 and the color pattern CP may include colorants, such as dyes or pigments for absorbing light in wavelength bands other than light of a specific wavelength band, and may be disposed to correspond to colors of the light emitting from the emission areas EA1, EA2, EA3, and EA4.

For example, the first color filter CF1 may be a red color filter disposed to overlap the first emission area EA1 and may transmit only the first light, which is the red light, therethrough. The second color filter CF2 may be a blue color filter disposed to overlap the second emission area EA2 and may transmit only the second light, which is the blue light, therethrough. The color pattern CP may be a green color filter disposed to overlap the third emission area EA3 and the fourth emission area EA4 and may transmit only the third light, which is the green light, therethrough.

The first color filter CF1 may be disposed to overlap the first emission area EA1 and may be disposed so as not to overlap (e.g., to be offset from) the second emission area EA2, the third emission area EA3, and the fourth emission area EA4. The second color filter CF2 may be disposed to overlap the second emission area EA2 and may be disposed so as not to overlap the first emission area EA1, the third emission area EA3, and the fourth emission area EA4. The color pattern CP may be disposed to overlap the third emission area EA3 and the fourth emission area EA4 and may be disposed so as not to overlap the first emission area EA1 and the second emission area EA2. The color filters CF1 and CF2 and the color pattern CP may be disposed to overlap the non-emission area NEA.

According to an embodiment, the plurality of color filters CF1 and CF2 and the color pattern CP may be disposed to partially overlap other adjacent color filters CF1 and CF2 and color pattern CP. FIG. 9 illustrates an arrangement of the color filters CF1 and CF2 and the color pattern CP viewed from the side, and the color filters CF1 and CF2 and the color patterns CP may overlap each other in the non-emission area NEA.

In the display device 10, the color filters CF1 and CF2 and the color pattern CP are disposed to overlap each other, and accordingly, an intensity of reflected external light may be reduced. Furthermore, a color feeling caused by the reflected external light may be controlled by adjusting an arrangement, shapes, areas, and the like, of the color filters CF1 and CF2 and the color pattern CP in a plan view.

A touch electrode TL may be disposed between the emission areas EA1, EA2, EA3, and EA4. The touch electrode TL may be disposed to extend in the fourth direction DR4 and the fifth direction DR5, may not overlap the emission areas EA1, EA2, EA3, and EA4, and may be spaced apart from the emission areas EA1, EA2, EA3, and EA4. The touch electrode TL may be disposed to overlap a pixel defining film PDL (see, e.g., FIG. 9) including the openings OPE1, OPE2, OPE3, and OPE4 and a light blocking layer BM (see, e.g., FIG. 9) including a plurality of holes OPT1, OPT2, OPT3, and OPT4, to be described later. Although the touch electrode TL has been briefly described with reference to FIG. 8, the touch electrode TL may be either the touch driving electrode TE or the sensing electrode RE shown in FIG. 7.

Diameters of the openings OPE1, OPE2, and OPE3 forming the emission areas EA1, EA2, EA3, and EA4 may be smaller than diameters of holes OPT1, OPT2, OPT3, and OPT4. The holes OPT1, OPT2, OPT3, and OPT4 may be defined between areas in which the first color filter CF1, the second color filter CF2, and the color pattern CP overlap each other. Opening intervals between the openings OPE1, OPE2, OPE3, and OPE4 and the holes OPT1, OPT2, OPT3, and OPT4 may be defined for each of the emission areas EA1, EA2, EA3, and EA4. The opening intervals may be defined as differences in diameter between the openings OPE1, OPE2, OPE3, and OPE4 in the pixel defining film PDL and the holes OPT1, OPT2, OPT3, and OPT4. In the display device 10, the opening intervals between the openings OPE1, OPE2, OPE3, and OPE4 and the holes OPT1, OPT2, OPT3, and OPT4 in the same emission areas EA1, EA2, EA3, and EA4 belonging to different pixels PX1, PX2, and PX3 may be different from each other. In the first pixel PX1, the second pixel PX2, and the third pixel PX3, the emission areas EA1, EA2, EA3, and EA4 emit light of the same color, but the opening intervals between the openings OPE1, OPE2, OPE3, and OPE4 and the holes OPT1, OPT2, OPT3, and OPT4 in the emission areas EA1, EA2, EA3, and EA4 may be different from each other.

For example, the first to third pixels PX1, PX2, and PX3 may include the first emission areas EA1 emitting the red light, respectively, but opening intervals of the first emission areas EA1 in the respective pixels PX1, PX2, and PX3 may be different from each other. Similarly, in the first to third pixels PX1, PX2, and PX3, the second to fourth emission areas EA2, EA3, and EA4 may emit light of the same color, but opening intervals of the second to fourth emission areas EA2, EA3, and EA4 in the first to third pixels PX1, PX2, and PX3 may be different from each other. In addition, within the respective pixels PX1, PX2, PX3, and PX4, opening intervals of the first to fourth emission areas EA1, EA2, EA3, and EA4 may different from each other.

FIG. 9 is a cross-sectional view taken along the line X-X' in FIG. 8. FIG. 9 illustrates a cross-section taken along the first emission area EA1, the third emission area EA3, and the second emission area EA2.

A cross-sectional structure of the display device 10 will be described with reference to FIG 9 in addition to FIG. 8. The display panel 100 of the display device 10 may include a display layer DU, a touch sensing layer TSU, and a reflection reduction layer RPL. The display layer DU may include a substrate SUB, a thin film transistor layer TFTL, a light emitting element layer EML, and an encapsulation layer TFEL. The display panel 100 may include the reflection reduction layer RPL disposed on the touch sensing layer TSU, and the reflection reduction layer RPL may include a light blocking layer BM and a color filter layer CFL.

The substrate SUB may be a base substrate or a base member. The substrate SUB may be a flexible substrate that may be bent, folded, and rolled. As an example, the substrate SUB may include a polymer resin, such as polyimide (PI), but is not limited thereto. As another example, the substrate SUB may include a glass material or a metal material.

The thin film transistor layer TFTL may include a first buffer layer BF1, a bottom metal layer BML, a second buffer layer BF2, thin film transistors TFT, a gate insulating layer GI, a first interlayer insulating layer ILD1, capacitor electrodes CPE, a second interlayer insulating layer ILD2, first connection electrodes CNE1, a first passivation layer PAS1, second connection electrodes CNE2, and a second passivation layer PAS2.

The first buffer layer BF1 may be disposed on the substrate SUB. The first buffer layer BF1 may include an inorganic film for preventing permeation of air or moisture. For example, the first buffer layer BF1 may include a plurality of inorganic films that are alternately stacked on each other.

The bottom metal layer BML may be disposed on the first buffer layer BF1. For example, the bottom metal layer BML may be formed as a single layer or multiple layers made of any one of molybdenum (Mo), aluminum (Al), chromium (Cr), gold (Au), titanium (Ti), nickel (Ni), neodymium (Nd), tantalum (Ta), and copper (Cu), or alloys thereof.

The second buffer layer BF2 may cover the first buffer layer BF1 and the bottom metal layer BML. The second buffer layer BF2 may include an inorganic film for preventing permeation of air or moisture. For example, the second buffer layer BF2 may include a plurality of inorganic films that are alternately stacked on each other.

The thin film transistor TFT may be disposed on the second buffer layer BF2 and may constitute a pixel circuit of each of the plurality of pixels. For example, the thin film transistor TFT may be a driving transistor or a switching transistor of the pixel circuit. The thin film transistor TFT may include a semiconductor layer ACT, a source electrode SE, a drain electrode DE, and a gate electrode GE.

The semiconductor layer ACT may be disposed on the second buffer layer BF2. The semiconductor layer ACT may overlap the bottom metal layer BML and the gate electrode GE in the thickness direction and may be insulated from the gate electrode GE by the gate insulating layer GI. A material of the semiconductor layer ACT at portions of the semiconductor layer ACT may become conductors (e.g., may be doped to become conductors) to form the source electrode SE and the drain electrode DE.

The gate electrode GE may be disposed on the gate insulating layer GI. The gate electrode GE may overlap the semiconductor layer ACT with the gate insulating layer GI interposed therebetween.

The gate insulating layer GI may be disposed on the semiconductor layer ACT. For example, the gate insulating layer GI may cover the semiconductor layer ACT and the second buffer layer BF2 and may insulate the semiconductor layer ACT and the gate electrode GE from each other. The gate insulating layer GI may include contact holes (e.g., contact openings) through which the first connection electrodes CNE1 penetrate (or extend).

The first interlayer insulating layer ILD1 may cover the gate electrode GE and the gate insulating layer Gl. The first interlayer insulating layer ILD1 may include contact holes (e.g., contact openings) through which the first connection electrodes CNE1 penetrate (or extend). The contact holes in the first interlayer insulating layer ILD1 may be connected to (e.g., may be in communication with) the contact holes in the gate insulating layer GI and contact holes in the second interlayer insulating layer ILD2.

The capacitor electrodes CPE may be disposed on the first interlayer insulating layer ILD1. The capacitor electrode CPE may overlap the gate electrode GE in the thickness direction. The capacitor electrode CPE and the gate electrode GE may form capacitance therebetween.

The second interlayer insulating layer ILD2 may cover the capacitor electrodes CPE and the first interlayer insulating layer ILD1. The second interlayer insulating layer ILD2 may include contact holes (e.g., contact openings) through which the first connection electrodes CNE1 penetrate (or extend). The contact holes in the second interlayer insulating layer ILD2 may be connected to (e.g., may be in communication with) the contact holes in the first interlayer insulating layer ILD1 and the contact holes in the gate insulating layer Gl.

The first connection electrodes CNE1 may be disposed on the second interlayer insulating layer ILD2. The first connection electrode CNE1 may electrically connect the drain electrode DE of the thin film transistor TFT and the second connection electrode CNE2 to each other. The first connection electrode CNE1 may be inserted into (or may be formed in) the contact holes formed in the second interlayer insulating layer ILD2, the first interlayer insulating layer ILD1, and the gate insulating layer GI to be in contact with the drain electrode DE of the thin film transistor TFT.

The first passivation layer PAS1 may cover the first connection electrode CNE1 and the second interlayer insulating layer ILD2. The first passivation layer PAS1 may protect the thin film transistor TFT. The first passivation layer PAS1 may include contact holes (e.g., contact openings) through which the second connection electrodes CNE2 penetrate (or extend).

The second connection electrodes CNE2 may be disposed on the first passivation layer PAS1. The second connection electrode CNE2 may electrically connect the first connection electrode CNE1 and a pixel electrode AE of a light emitting element ED to each other. The second connection electrode CNE2 may be inserted into (or may be formed in) the contact hole formed in the first passivation layer PAS1 to be in contact with the first connection electrode CNE1.

The second passivation layer PAS2 may cover the second connection electrodes CNE2 and the first passivation layer PAS1. The second passivation layer PAS2 may include contact holes (e.g., contact openings) through which the pixel electrodes AE of the light emitting elements ED penetrate (or extend).

The light emitting element layer EML may be disposed on the thin film transistor layer TFTL. The light emitting element layer EML may include light emitting elements ED and a pixel defining film PDL. The light emitting element ED may include the pixel electrode AE, a light emitting layer EL, and a common electrode CO.

The pixel electrode AE may be disposed on the second passivation layer PAS2. The pixel electrode AE may be disposed to overlap any one of the openings OPE1, OPE2, OPE3, and OPE4 in the pixel defining film PDL. The pixel electrode AE may be electrically connected to the drain electrode DE of the thin film transistor TFT through the first and second connection electrodes CNE1 and CNE2.

The light emitting layer EL may be disposed on the pixel electrode AE. For example, the light emitting layer EL may be an organic light emitting layer made of an organic material, but it is not limited thereto. In an embodiment in which the light emitting layer EL is an organic light emitting layer, when the thin film transistor TFT applies a voltage (e.g., a driving voltage) to the pixel electrode AE of the light emitting element ED and the common electrode CO of the light emitting element ED receives a common voltage (or a cathode voltage), holes and electrons may move to the light emitting layer EL through (or from) a hole transporting layer and an electron transporting layer, respectively, and may be combined with each other in the light emitting layer EL to emit light.

The common electrode CO may be disposed on the light emitting layer EL. For example, the common electrode CO is not divided for each of the plurality of pixels and may be implemented in the form of an electrode that is common to all the pixels. The common electrode CO may be disposed on the light emitting layers EL in the first to fourth emission areas EA1, EA2, EA3, and EA4 and may be disposed on the pixel defining film PDL in an area other than the first to fourth emission areas EA1, EA2, EA3, and EA4.

The common electrode CO may receive the common voltage or a low potential voltage (ELVSS). When the pixel electrode AE receives a voltage corresponding to a data voltage (or driving voltage) and the common electrode CO receives the low potential voltage, a potential difference is formed between the pixel electrode AE and the common electrode CO, such that the light emitting layer EL may emit light.

The pixel defining film PDL may have the plurality of openings OPE1, OPE2, OPE3, and OPE4 and may be disposed on the second passivation layer PAS2 and portions of the pixel electrodes AE. The pixel defining film PDL may include the first opening OPE1, the second opening OPE2, the third opening OPE3, and the fourth opening OPE4, and the respective openings OPE1, OPE2, OPE3, and OPE4 may expose portions of the pixel electrode AE. As described above, the openings OPE1, OPE2, OPE3, and OPE4 in the pixel defining film PDL may define the first to fourth emission areas EA1, EA2, EA3, and EA4, respectively, and may have different areas or sizes. The pixel defining film PDL may space and insulate the pixel electrodes AE of a plurality of light emitting elements ED from each other. The pixel defining film PDL may include a light absorbing material to prevent light reflection. For example, the pixel defining film PDL may include a polyimide (PI)-based binder and a pigment in which red, green, and blue are mixed with each other. In another embodiment, the pixel defining film PDL may include a cardo-based binder resin and a mixture of a lactam black pigment and a blue pigment. In another embodiment, the pixel defining film PDL may include carbon black.

The encapsulation layer TFEL may be disposed on the common electrodes CO to cover the plurality of light emitting elements ED. The encapsulation layer TFEL may include at least one inorganic film to prevent oxygen or moisture from permeating into the light emitting element layer EML. The encapsulation layer TFE may include at least one organic film to protect the light emitting element layer EML from foreign substances, such as dust.

In an embodiment, the encapsulation layer TFEL may include a first encapsulation layer TFE1, a second encapsulation layer TFE2, and a third encapsulation layer TFE3. The first encapsulation layer TFE1 and the third encapsulation layer TFE3 may be inorganic encapsulation layers, and the second encapsulation layer TFE2 disposed between the first encapsulation layer TFE1 and the third encapsulation layer TFE3 may be an organic encapsulation layer.

Each of the first encapsulation layer TFE1 and the third encapsulation layer TFE3 may include one or more inorganic insulating materials. The inorganic insulating material may include aluminum oxide, titanium oxide, tantalum oxide, hafnium oxide, zinc oxide, silicon oxide, silicon nitride, and/or silicon oxynitride.

The second encapsulation layer TFE2 may include a polymer-based material. The polymer-based material may include an acrylic resin, an epoxy-based resin, polyimide, polyethylene, and the like. For example, the second encapsulation layer TFE2 may include an acrylic resin, such as polymethyl methacrylate or polyacrylic acid. The second encapsulation layer TFE2 may be formed by curing a monomer or applying a polymer.

The touch sensing layer TSU may be disposed on the encapsulation layer TFEL. The touch sensing layer TSU may include a first touch insulating layer SIL1, a second touch insulating layer SIL2, touch electrodes TL, and a third touch insulating layer SIL3.

The first touch insulating layer SIL1 may be disposed on the encapsulation layer TFEL. The first touch insulating layer SIL1 may have insulating and optical properties. The first touch insulating layer SI L1 may include at least one inorganic film or organic film. In some embodiments, the first touch insulating layer SIL1 may be omitted.

The second touch insulating layer SIL2 may cover the first touch insulating layer SIL1. Touch electrodes of another layer may be further disposed on the first touch insulating layer SI L1, and the second touch insulating layer SIL2 may cover such touch electrodes. The second touch insulating layer SIL2 may have insulating and optical properties. For example, the second touch insulating layer SIL2 may be an inorganic film including at least one of a silicon nitride layer, a silicon oxynitride layer, a silicon oxide layer, a titanium oxide layer, and an aluminum oxide layer, or an organic film.

Some of the touch electrodes TL may be disposed on the second touch insulating layer SIL2. Each of the touch electrodes TL may not overlap the first to fourth emission areas EA1, EA2, EA3, and EA4. Each of the touch electrodes TL may be formed as a single layer made of molybdenum (Mo), titanium (Ti), copper (Cu), tantalum (Ta), aluminum (Al), or indium tin oxide (ITO), or may be formed as a stacked structure of aluminum and titanium (e.g., Ti/Al/Ti), a stacked structure of aluminum and ITO (e.g., ITO/AI/ITO), an APC alloy, and a stacked structure of an APC alloy and ITO (e.g., ITO/APC/ITO).

The third touch insulating layer SIL3 may cover the touch electrodes TL and the second touch insulating layer SIL2. The third touch insulating layer SIL3 may have insulating and optical properties. The third touch insulating layer SIL3 may be made of the material described above of the second touch insulating layer SIL2.

The reflection reduction layer RPL may be disposed on the touch sensing layer TSU. The reflection reduction layer RPL may include the light blocking layer BM and the color filter layer CFL. The display device 10, according to an embodiment, includes the reflection reduction layer RPL implemented by the light blocking layer BM and the color filter layer CFL such that a polarizing layer attached onto the display layer DU through a separate bonding member, such as a pressure sensitive adhesive (PSA) or an optical clear adhesive (OCA), may be omitted.

The light blocking layer BM may be disposed on the third touch insulating layer SIL3 of the touch sensing layer TSU. The light blocking layer BM may be disposed to cover conductive lines of the touch electrodes TL and may have the plurality of holes OPT1, OPT2, OPT3, and OPT4 disposed to overlap the emission areas EA1, EA2, EA3, and EA4. For example, a first hole OPT1 may be disposed to overlap the first emission area EA1 or the first opening OPE1. A second hole OPT2 may be disposed to overlap the second emission area EA2 or the second opening OPE2, and a third hole OPT3 may be disposed to overlap the third emission area EA3 or the third opening OPE3. A fourth hole OPT4 may be disposed to overlap the fourth emission area EA4 or the fourth opening OPE4. Areas or sizes of the respective holes OPT1, OPT2, OPT3, and OPT4 may be greater than areas or sizes of the corresponding openings OPE1, OPE2, OPE3, and OPE4 in the pixel defining film PDL. The holes OPT1, OPT2, OPT3, and OPT4 in the light blocking layer BM are formed to be greater in size than the corresponding openings OPE1, OPE2, OPE3, and OPE4 in the pixel defining film PDL, and accordingly, the light emitted from the emission areas EA1, EA2, EA3, and EA4 may be viewed by a user not only from a front surface of the display device 10 but also from side surfaces of the display device 10.

The light blocking layer BM may include a light absorbing material. For example, the light blocking layer BM may include an inorganic black pigment or an organic black pigment. The inorganic black pigment may be carbon black, and the organic black pigment may include at least one of lactam black, perylene black, and aniline black, but the present disclosure is not limited thereto. The light blocking layer BM may prevent color mixing due to permeation of visible light between the first to fourth emission areas EA1, EA2, EA3, and EA4 to improve a color gamut of the display device 10.

The color filters CF1, CF2, CF3, and CF4 of the color filter layer CFL may be disposed on the light blocking layer BM. Different color filters CF1, CF2, CF3, and CF4 may be disposed to correspond to the different emission areas EA1, EA2, EA3, and EA4 or openings OPE1, OPE2, OPE3, and OPE4 and the holes OPT1, OPT2, OPT3, and OPT4 in the light blocking layer BM, respectively. For example, the first color filter CF1 may be disposed to correspond to the first emission area EA1, the second color filter CF2 may be disposed to correspond to the second emission area EA2, and the third color filter CF3 may be disposed to correspond to the third emission area EA3. The first color filter CF1 may be disposed in the first hole OPT1 in the light blocking layer BM, the second color filter CF2 may be disposed in the second hole OPT2 in the light blocking layer BM, and the third color filter CF3 may be disposed in the third hole OPT3 in the light blocking layer BM. The fourth color filter CF4 may be disposed in the fourth hole OPT4 in the light blocking layer BM to correspond to the fourth emission area EA4. Each of the color filters CF1, CF2, CF3, and CF4 may have a greater area than each of the holes OPT1, OPT2, OPT3, and OPT4 in the light blocking layer BM in a plan view, and portions of each of the color filters CF1, CF2, CF3, and CF4 may be directly disposed on the light blocking layer BM.

A planarization layer OC may be disposed on the color filters CF1, CF2, CF3, and CF4 to planarize upper ends of the color filters CF1, CF2, CF3, and CF4. The planarization layer OC may be a colorless, light transmitting layer that does not have a color in a visible light band. For example, the planarization layer OC may include a colorless light transmitting organic material, such as an acrylic resin.

According to an embodiment, the color filters CF1, CF2, CF3, and CF4 of the display device 10 may be disposed to overlap other color filters CF1, CF2, CF3, and CF4 adjacent thereto on the light blocking layer BM. The color filters CF1, CF2, CF3, and CF4 disposed on the light blocking layer BM may be disposed so that two color filters CF1, CF2, CF3, and CF4 adjacent to each other completely cover the light blocking layer BM. The two color filters CF1, CF2, CF3, and CF4 adjacent to each other may be disposed to partially overlap each other on the light blocking layer BM. Such overlap between the color filters CF1, CF2, CF3, and CF4 may reduce external light reflection due to the light blocking layer BM, and an overlap arrangement of the color filters CF1, CF2, CF3, and CF4 may be designed to further reduce external light reflection.

For example, in the display device 10, the first color filter CF1 and the third color filter CF3 adjacent to each other may be disposed to overlap each other on the light blocking layer BM, and the second color filter CF2 and the third color filter CF3 may also be disposed to overlap each other on the light blocking layer BM. The first color filter CF1 and the fourth color filter CF4 adjacent to each other and the second color filter CF2 and the fourth color filter CF4 adjacent to each other may also be disposed to overlap each other on the light blocking layer BM.

The light blocking layer BM may include a material for absorbing light, but some of the light incident from the outside may also be reflected by the light blocking layer BM. The color filters CF1, CF2, CF3, and CF4 disposed in the holes OPT1, OPT2, OPT3, and OPT4 in the light blocking layer BM may be partially disposed directly on the light blocking layer BM and may be disposed to completely cover the light blocking layer BM. The two different color filters CF1, CF2, CF3, and CF4 adjacent to each other may include different colorants and may be disposed to overlap each other on the light blocking layer BM, and accordingly, external light reflection due to the light blocking layer BM may be reduced. However, transmissivity of the color filters CF1, CF2, CF3, and CF4 may change depending on materials constituting the color filters CF1, CF2, CF3, and CF4, and reflection of external light may be more effectively reduced according to the overlap order of the color filters CF1, CF2, CF3, and CF4.

Hereinafter, the optical film OPF disposed in front of the cover window CW will be described.

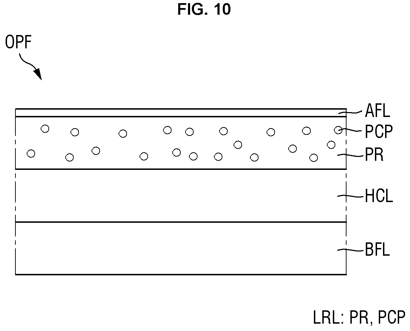

FIG. 10 is a schematic cross-sectional view of an optical film of the display device according to an embodiment.

Referring to FIG. 10, the optical film OPF, according to an embodiment, may include a base layer BFL, a hard coating layer HCL disposed on the base layer BFL, a low refraction layer LRL disposed on the hard coat layer HCL, and an anti-fingerprint layer AFL disposed on the low refraction layer LRL.

The base layer BFL may include a transparent polymer film. The transparent polymer film may include at least one of polyethylene terephthalate (PET), polyethylene naphthalate (PEN), polyether sulfone (PES), polyimide (PI), polyarylate (PAR), polycarbonate (PC), polymethyl methacrylate (PMMA), triacetyl cellulose (TAC), a cycloolefin copolymer (COC), or a polyether block amide (PEBA) resin. However, the present disclosure is not limited thereto.

In addition, the base layer BFL may be formed of a self-restoring composition including an elastomer resin based on any one of silicone, urethane, and urethane acrylate, such that urethane acrylate resins in the base layer BFL may have a ladder structure in which they may be supported by an aromatic group, a heteroaromatic group, or both of the aromatic group and the heteroaromatic group.

The aromatic urethane acrylate resin may be a urethane acrylate resin with an average number of functional groups in a range of 2 to 5 and may be formed by a reaction of a polymerizable composition including an acrylate including a hydroxy group and an isocyanate compound. At least one of the acrylate including the hydroxy group and the isocyanate compound may include an aromatic group, a heteroaromatic group, or both of the aromatic group and the heteroaromatic group, but the present disclosure is not limited thereto.

In an embodiment, the base layer BFL may have a single-layer structure. For example, the base layer BFL may be configured as one base layer. However, the present disclosure is not limited thereto, and the base layer BFL may have a multilayer structure.

The base layer BFL may have a thickness in a range of 50 µm to 200 µm. The base layer BFL may have sufficient bendability and self-restoring properties by having a thickness in the above range and, thus, may provide uniform performance.

The base layer BFL, which is the base of the optical film OPF, is manufactured by elongating the material in one direction so that the base layer BFL has a machine direction MD and a transverse direction TD transverse to the machine direction MD. In other words, the base layer BFL may comprise a material (e.g. the transparent polymer film and /or self-restoring composition as disclosed above) having a structure caused by elongating the material in one direction, i.e. the material has structural characteristics in the machine direction MD (of elongation) and in a transverse direction TD transverse to the machine direction MD. One of said structural characteristics may be the crack strain, which differs depending on the direction in which it is measured. The base layer BFL may be calendered, i.e. manufactured in a calender process.

To mitigate or prevent cracks due to folding, the base layer BFL may have a crack strain of 5% or more in the machine direction MD and the transverse direction TD.

The hard coating layer HCL may be disposed on the base layer BFL. The hard coating layer HCL may reduce distortion or lifting phenomena of the optical film OPF under a harsh condition, such as high temperature or high temperature and high humidity and, thus, may improve reliability.

The hard coating layer HCL may include an organic layer. The organic layer may include at least one of polyimide, polycarbonate, polyethersulfone, polyethylene naphthalate, polyphenylene sulfide, a liquid crystal polymer (LCP), polymethyl methacrylate, an acrylic polymer, and an epoxy-based polymer, or combinations thereof.

In another embodiment, the hard coating layer HCL may include an organic layer and an organic-inorganic composite layer. In such an embodiment, the organic layer may include an acrylate-based compound. For example, the organic layer may include urethane acrylate. The organic layer may be disposed between the base layer BFL and the organic-inorganic composite layer to act as a stress buffer layer.

An organic material in the organic-inorganic composite layer may be at least one of an acrylate-based compound, a polyurethane-based compound, or an epoxy-based compound, or combinations thereof. For example, the organic material may include urethane acrylate. An inorganic material in the organic-inorganic composite layer may be at least one selected from the group consisting of silicon oxide (e.g., SiOz), zirconium oxide (e.g., ZrOz), aluminum oxide (e.g., Al₂O₃), tantalum oxide (e.g., Ta₂O₅), niobium oxide (e.g., Nb₂O₅ or NbO₂), and glass beads.

The inorganic material may be provided in the form of a single type of inorganic oxide listed above or mixtures thereof. In addition, the inorganic material may be provided in various forms to form the organic-inorganic composite layer. For example, silicon oxide may be provided in the form of particles, sol, or a hollow shape.

In the organic-inorganic composite layer, the acrylate compound, which is the organic material, and inorganic particles may be mixed with each other and provided at a weight ratio in a range of 5:5 to 8:2. The organic-inorganic composite layer may form the hard coating layer HCL, which is not easily broken, by including both the acrylate compound and the inorganic particles to have shock absorbency against external shock while improving surface hardness.

The hard coating layer HCL may have a thickness in a range of 2 µm to 10 µm, preferably, 5 µm to 8 µm. The hard coating layer HCL may reduce the distortion or lifting phenomena by having the thickness in the above range and, thus, may improve reliability.

The hard coating layer HCL may have a crack strain of about 1.5% or more to prevent cracks due to folding. In some embodiments, the hard coating layer HCL may have a crack strain of 2% or more.

The low refraction layer LRL may be disposed on the hard coating layer HCL. The low refraction layer LRL may refract light emitted from the light emitting element layer upwardly to increase emission efficiency and reduce reflection of external light.

The low refraction layer LRL may include particles PCP dispersed in a transparent resin PR.

The resin PR may include one or more selected from the group consisting of acryl, polysiloxane, polyurethane, polyurethane acrylate, polyimide, polymethylsilsesquioxane (PMSSQ), and polymethyl methacrylate (PMMA).

The particles PCP may be particles having a hollow. For example, the particles PCP may include one or more selected from the group consisting of silica (e.g., SiOz), magnesium fluoride (e.g., MgF₂), and iron oxide (e.g., Fe₃O₄). In addition, the particles PCP may include a shell made of one or more of the above materials and a hollow inside the shell. In an embodiment, a diameter (average particle diameter D50 determined by SEM analysis) of the particle PCP may be in a range of 10 nm to 200 nm, preferably 50 µm to 150 µm, and a thickness of the shell and a diameter of the hollow may be determined according to the diameter of the particle PCP.

The particles PCP included in the low refraction layer LRL may be included in a weight ratio in a range of 10% to 50% with respect to the resin PR. When the weight ratio of the particles PCP to the resin PR is 10% or more, a refractive index of the low refraction layer LRL may be lowered, and when the weight ratio of the particles PCP to the resin PR is 50% or less, adhesion to adjacent layers may be deteriorated. The low refraction layer LRL may be formed by coating and curing a solution including the resin PR and a solvent in which the particles PCP are dispersed.

The low refraction layer LRL may have a thickness in a range of 10 nm to 200 nm. The low refraction layer LRL may decrease a refractive index and improve adhesion to a lower layer by having the thickness in the above thickness range to sufficiently include the particles PCP.

The refractive index of the low refraction layer LRL may be smaller than the refractive index of the hard coating layer HCL to reduce reflection of external light. For example, the refractive index of the low refraction layer LRL may be in a range of about 1.3 to about 1.48. However, the present disclosure is not limited thereto, and a lower refractive index may be used as long as it is smaller than the refractive index of the hard coating layer HCL. The refractive index of a thin film may be measured using an ABBE Refractometer (ATAGO Corporation).

The anti-fingerprint layer AFL may be disposed on the low refraction layer LRL. The optical film OPF may be exposed to the outside and may be touched by a user's finger, or the like. That is, a surface of the optical film OPF may be used as a touch surface for a touch sensor. The anti-fingerprint layer AFL may prevent a user's fingerprint from remaining by including a water-repellent or oil-repellent material to improve contamination resistance.

The anti-fingerprint layer AFL may include an acrylate-based compound and a fluorine-based additive. As an example, the anti-fingerprint layer AFL may be a layer including a fluorine-containing silane compound in which a silane portion and a fluorinated carbon portion are connected to each other by an alkyl chain. In another embodiment, the fluorine-based additive may include one of polytetrafluoroethylene (PTFE), polyvinylidene fluoride (PVDF), and amorphous fluorine containing polymers (e.g., Teflon^{™} AF or Cytop^{®}).

The anti-fingerprint layer AFL may have a thickness in a range of 5 nm to 30 nm. The anti-fingerprint layer AFL may maintain or improve anti-fingerprint characteristics by having a thickness in the above range.

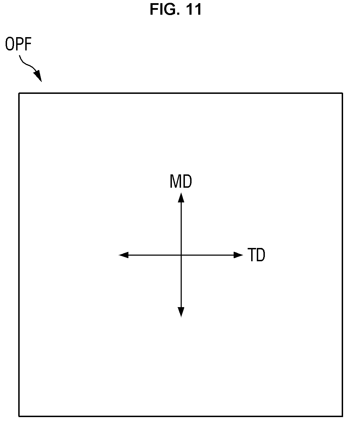

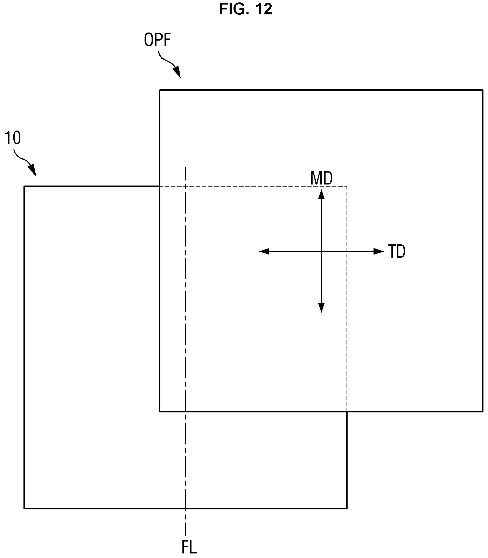

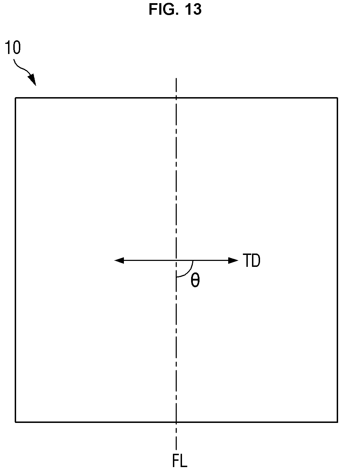

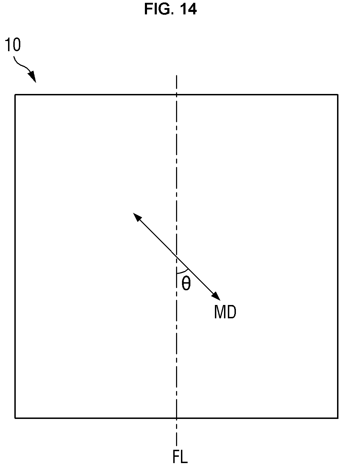

FIG. 11 is a plan view illustrating a direction transverse to a machine direction of an optical film according to an embodiment. FIG. 12 is a plan view illustrating a direction transverse to a machine direction of a folding axis and an optical film of a display device. FIG. 13 is a plan view illustrating a direction transverse to a folding axis and an optical film of a display device. FIG. 14 is a plan view illustrating the machine direction of a folding axis and an optical film of a display device.

Referring to FIGS. 11 to 13 in conjunction with FIG. 10, the optical film OPF described above may be formed by sequentially stacking a hard coating layer HCL, a low refractive index layer LRL, and an anti-fingerprint layer AFL on the base layer BFL. The machine direction MD and transverse direction TD of the base layer BFL act as the machine direction MD and transverse direction TD of the optical film OPF.

The optical film OPF may have different crack strain values depending on the machine direction MD and the transverse direction TD. Crack strain refers to a degree to which an object, such as a film, may withstand force when the force is applied in any one direction, and the greater the crack strain, the higher the resistance to a crack. The crack strain may be measured by nanoindentation.

The display device 10 may be folded and unfolded about the folding axis FL. When the display device 10 is repeatedly folded and unfolded, a crack may occur in the optical film OPF. In an embodiment, a greater strain of a crack strain of the optical film OPF in a transverse direction TD and a crack strain of the optical film OPF in a machine direction MD may be 2% or more. For example, a crack strain of the optical film OPF in a transverse direction TD and a crack strain of the optical film OPF in a machine direction MD may be in a range of 2% to 10%. When the greater strain of the crack strain of the optical film OPF in the transverse direction TD and the crack strain of the optical film OPF in the machine direction MD is 2% or more, the occurrence of a crack in the optical film OPF may be suppressed due to a strain generated by the folding and unfolding of the display device 10. The greater strain of the crack strain of the optical film OPF in the transverse direction TD and the crack strain of the optical film OPF in the machine direction MD may be, in some embodiments, 4% or more.

In addition, in an embodiment, the optical film OPF may be arranged to cross the folding axis FL in the direction in which crack strain is greater from among the machine direction MD and the transverse direction TD. For example, to suppress the occurrence of cracks in the optical film OPF during the folding and unfolding of the display device 10, the machine direction MD or transverse direction TD in which crack strain is relatively large is aligned to cross (e.g., intersect) the folding axis FL. The angle between the folding axis FL and the direction in which crack strain is greater from among the machine direction MD and the transverse direction TD of the optical film OPF may be in a range from 15° to 120°.

As illustrated in FIGS. 12 and 13, in an embodiment, when the crack strain in the transverse direction TD of the optical film OPF is greater than the crack strain in the machine direction MD of the optical film OPF, the angle θ between the transverse direction TD of the optical film OPF and the folding axis FL of the display device 10 may be about 90°. When the display device 10 is folded about the folding axis FL, the direction of strain applied to the optical film OPF may be transverse to the folding axis FL. Therefore, when the transverse direction TD of the optical film OPF is arranged transverse to the folding axis FL, the direction of the strain applied to the optical film OPF and the transverse direction TD in which the crack strain of the optical film OPF is relatively large may coincide, thereby suppressing the occurrence of cracks in the optical film OPF due to folding of the display device 10. In another embodiment, when the crack strain in the machine direction MD of the optical film OPF is greater than the crack strain in the transverse direction TD, the angle θ between the machine direction MD of the optical film OPF and the folding axis FL of the display device 10 may be about 90°.

As illustrated in FIG. 14, in another embodiment, when the crack strain in the machine direction MD of the optical film OPF is greater than the crack strain in the transverse direction TD of the optical film OPF, the angle θ between the machine direction MD of the optical film OPF and the folding axis FL of the display device 10 may be 45°. For example, when the machine direction MD of the optical film OPF is arranged diagonally with respect to the folding axis FL, the transverse direction TD with a relatively small crack strain does not coincide with the direction of strain applied to the optical film OPF, thereby suppressing the occurrence of cracks in the optical film OPF due to folding of the display device 10.

As described above, the display device 10, according to an embodiment, may be arranged so that the folding axis FL crosses (e.g., intersects) the machine direction MD or the transverse direction TD in which crack strain is relatively large so that the occurrence of cracks in the optical film OPF due to folding of the display device 10 can be suppressed.

Hereinafter, various embodiments of the optical film of the display device will be described.

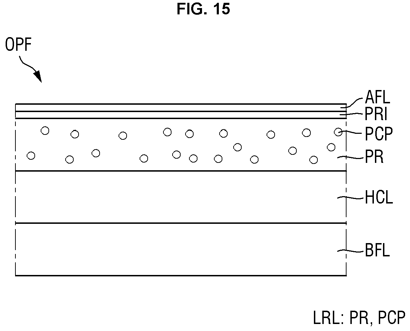

FIG. 15 is a cross-sectional view illustrating an optical film according to another embodiment.

Referring to FIG. 15, the illustrated embodiment is different from the embodiment described above with reference to FIG. 10 in that the optical film OPF further includes a primer layer PRI. Hereinafter, a description of content overlapping that of the above-described embodiment will be omitted, and content different from that of the above-described embodiment will be primarily described.

The optical film OPF, according to the present embodiment, may include a base layer BFL, a hard coating layer HCL disposed on the base layer BFL, a low refraction layer LRL disposed on the hard coat layer HCL, the primer layer PRI disposed on the low refraction layer LRL, and an anti-fingerprint layer AFL disposed on the primer layer PRI.

The primer layer PRI may be disposed between the low refraction layer LRL and the anti-fingerprint layer AFL. The primer layer PRI may improve a coupling force between the anti-fingerprint layer AFL and the low refraction layer LRL. The primer layer PRI may be formed through a primer treatment process. Primer treatment may improve adhesion between a polymer film and a resin by performing polymer treatment on the polymer film.

The primer layer PRI may include an acryl, an ester, a urethane, or a siloxane-based polymer material. For example, the primer layer PRI may include a silane coupling agent and isocyanate.

The primer layer PRI may have a thickness in a range of about 10 nm to about 30 nm. The primer layer PRI may improve the coupling force between the anti-fingerprint layer AFL and the low refraction layer LRL in the above thickness range.

The optical film OPF including the primer layer PRI may be arranged to cross (e.g., intersect) the folding axis FL of the display device 10 and the machine direction MD or the transverse direction TD in which the crack strain is relatively large, so that the occurrence of cracks in the optical film OPF due to the folding of the display device 10 can be suppressed.

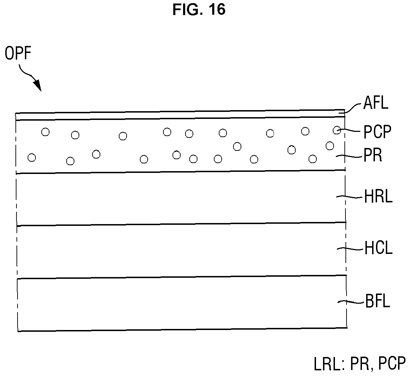

FIG. 16 is a cross-sectional view illustrating an optical film according to another embodiment.

Referring to FIG. 16, the illustrated embodiment is different from the embodiment described above with reference to FIG. 15 in that the optical film OPF further includes a high refraction layer HRL.

The optical film OPF, according to the present embodiment, may include a base layer BFL, a hard coating layer HCL disposed on the base layer BFL, the high refraction layer HRL disposed on the hard coat layer HCL, a low refraction layer LRL disposed on the high refraction layer HRL, and an anti-fingerprint layer AFL disposed on the low refraction layer LRL.

The high refraction layer HRL may be disposed between the hard coating layer HCL and the low refraction layer LRL. The high refraction layer HRL may be disposed below the low refraction layer LRL and may induce destructive interference of external light at an interface between the high refraction layer HRL and the low refraction layer LRL to reduce reflectivity.

The high refraction layer HRL may include an inorganic material, an organic material, or an inorganic material and an organic material. Therefore, the high refraction layer HRL may be formed as an inorganic film, an organic film, or an organic film including inorganic particles.

The inorganic material included in the high refraction layer HRL may be one or more selected from the group consisting of zinc oxide, titanium oxide, zirconium oxide, niobium oxide, tantalum oxide, tin oxide, nickel oxide, silicon oxide, silicon nitride, indium nitride, and gallium nitride.

The organic material included in the high refraction layer HRL may be one or more selected from the group consisting of poly(3,4-ethylenedioxythiophene) (PEDOT), 4,4'-bis[N-(3-methylphenyl)-N-phenylamino]biphenyl (TPD), 4,4',4"-tris[(3-methylphenyl)phenyl aminotriphenylamine (m-MTDATA), 1,3,5-tris[N,N-bis(2-methylphenyl)-amino]-benzene (o-MTDAB), 1,3,5-tris[N,N-bis(3-methylphenyl)-amino]-benzene (m-MTDAB), 1,3,5-tris[N,N-bis(4-methylphenyl)-amino]-benzene (p-MTDAB), 4,4'-bis[N,N-bis(3-methylphenyl)-amino]-diphenylmethane (BPPM), 4,4'-dicarbazolyl-1,1'-biphenyl (CBP), 4,4',4"-tris(N-carbazole)triphenylamine (TCTA), 2,2',2"-(1,3,5-benzentolyl)tris-[1-phenyl-1H-benzoimidazole] (TPBI), and 3-(4-biphenyl)-4-phenyl-5-t-butylphenyl-1,2,4-triazole (TAZ).

A refractive index of the high refraction layer HRL may be greater than a refractive index of the low refraction layer LRL to reduce reflection of external light. For example, the refractive index of the high refraction layer HRL may be in a range of 1.53 to 1.7. However, the present disclosure is not limited thereto, and a greater refractive index may be used as long as it is greater than the refractive index of the low refraction layer LRL.

The optical film OPF including the high refraction layer HRL may be arranged to cross (e.g., intersect) the folding axis FL of the display device 10 and the machine direction MD or the transverse direction TD in which crack strain is relatively large so that the occurrence of cracks in the optical film OPF due to the folding of the display device 10 can be suppressed.

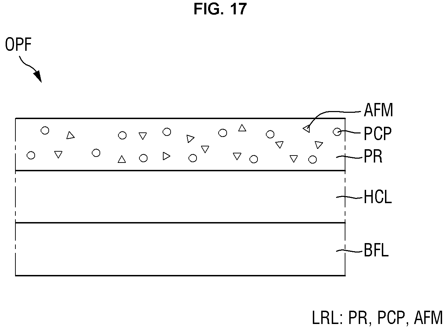

FIG. 17 is a cross-sectional view illustrating an optical film according to another embodiment.

Referring to FIG. 17, the illustrated embodiment is different from the embodiment described above with reference to FIG. 10 in that a composite layer CPL is disposed instead of the low refraction layer LRL and the anti-fingerprint layer AFL.

The optical film OPF, according to the present embodiment, may include a base layer BFL, a hard coating layer HCL disposed on the base layer BFL, and the composite layer CPL disposed on the hard coat layer HCL.

The composite layer CPL may be disposed on the hard coating layer HCL. The composite layer CPL may compositely act as the low refraction layer and the anti-fingerprint layer. The composite layer CPL may be disposed at the uppermost portion (or uppermost surface) of the optical film OPF and may reduce reflectivity of external light and may prevent a user's fingerprint from remaining.

The composite layer CPL may include particles PCP and anti-fingerprint materials AFM that are dispersed in a transparent resin PR. The resin PR and the particles PCP have been described in detail in connection with the description of the low refraction layer LRL, and accordingly, a repeated description thereof will be omitted. The composite layer CPL includes (or contains) the anti-fingerprint materials AFM along with the materials of the low refraction layer, such that contamination resistance of the composite layer CPL may be improved.

The anti-fingerprint material AFM may be a fluorine-based additive. The fluorine-based additive may include one of polytetrafluoroethylene (PTFE), polyvinylidene fluoride (PVDF), and amorphous fluorine containing polymers (e.g., Teflon^{™} AF or Cytop^{®}).

The composite layer CPL may have a thickness in a range of 10 nm to 200 nm. The composite layer CPL may lower a refractive index and may improve adhesion between the composite layer CPL and a lower layer by having a thickness in the above range to sufficiently include the particles PCP and may improve contamination resistance by including the anti-fingerprint materials AFM.

A refractive index of the composite layer CPL may be smaller than a refractive index of the hard coating layer HCL to reduce reflection of external light. For example, the refractive index of the composite layer CPL may be in a range of 1.3 to 1.48. However, the present disclosure is not limited thereto, and a lower refractive index may be used as long as it is smaller than the refractive index of the hard coating layer HCL.

The optical film OPF including the composite layer CPL may be arranged to cross (e.g., intersect) the folding axis FL of the display device 10 and the machine direction MD or the transverse direction TD in which crack strain is relatively large so that the occurrence of cracks in the optical film OPF due to the folding of the display device 10 can be suppressed.

Hereinafter, Experimental Examples including Examples will be provided to assist in the understanding of aspects and features of the present disclosure. However, it will be obvious to one of ordinary skill in the art that such Examples are only examples of the present disclosure and do not limit the claims, and various modifications and alterations may be made without departing from the scope of the present disclosure. In addition, these modifications and alterations will fall within the following claims and their equivalents.

### Manufacture Example 1: Manufacture of Optical Film

A base layer was formed having a thickness of 65 µm by machine PET in one direction. A hard coating layer was formed by applying a urethane acrylic resin having a thickness of 5 µm onto the base layer, and a low refraction layer was formed having a thickness of 100 nm by mixing an acrylic resin and silica particles with each other on the hard coating layer. An optical film was manufactured by mixing an acrylic resin and polytetrafluoroethylene with each other on the low refraction layer to form an anti-fingerprint layer having a thickness of 20 nm.

### Simulation

Compressive strain applied to the display panel attached with the optical film prepared in Manufacture Example 1 when folded at 1.55R was measured. As a result, the compressive strain applied to the hard coating layer was -1.45% and the compressive strain applied to the base layer was 3.54%.

Through the simulation results above, it was confirmed that an optical film with a crack strain of the hard coating layer of 1.5% or more and a crack strain of the base layer of 5% or more can suppress the occurrence of cracks when folding the display device.

### Embodiments

### Example 1

An optical film was manufactured under the same conditions as Manufacture Example 1, except that the hard coating layer was manufactured with urethane-acrylic resin with an acrylic to urethane ratio of 9:1.

### Example 2

An optical film was manufactured under the same conditions as Example 1 except that the hard coating layer was manufactured with urethane-acrylic resin with an acrylic to urethane ratio of 8:2.

### Example 3

An optical film was manufactured under the same conditions as Example 1 except that the hard coating layer was manufactured with urethane-acrylic resin with an acrylic to urethane ratio of 7:3.

### Experimental Example 1

### Evaluation of Crack Strain of Optical Film Sample

Crack strains, in a machine direction and a transverse direction, of the optical film manufactured according to Examples 1 to 3, were measured and are shown in Table 1. In Example 3, the crack strain at 45°, which is the angle between the transverse direction and the machine direction, was additionally measured. The crack strains were measured using a universal testing machine (UTM, Tensile Testing Equipment).

**Table 1**

| | Crack Strain (%) | | |
|---|---|---|---|
| | TD | MD | 45° |
| Manufacture Example 1 | 8 | 6 | - |
| Manufacture Example 2 | 5 | 4 | - |
| Manufacture Example 3 | 2 | 1 | 1.5 |

Referring to Table 1, the crack strain of the optical film according to Examples 1 to 3 in the transverse direction was 2% or more, and the crack strain of the optical film according to Example 1 in the transverse direction was greater than the crack strain of the optical film according to Example 1 in the machine direction.

### Manufacture Example 2: Manufacture of Display Device shown in FIG. 5

The display device shown in FIG. 5 was manufactured by attaching the optical film according to Example 3 onto a display panel to which a cover window is attached. In this Example, a barrier layer and a plate were also provided below the display panel.

### Example 4

A display device was manufactured by attaching the optical film so that the transverse direction of the optical film was transverse to the folding axis.

### Example 5

A display device was manufactured by attaching the optical film so that the machine direction of the optical film was transverse to the folding axis.

### Example 6

A display device was manufactured by attaching the optical film so that the transverse direction of the optical film was disposed at 45° with respect to the folding axis.

### Experimental Example 2

### Low-temperature Folding Test of Display Device

The presence or absence of cracks in the optical films was observed while performing a folding test in which folding and unfolding were repeated 30,000 times at a low temperature of -20°C on the display devices manufactured according to Examples 4 to 6, and a test result are shown in Table 2.

**Table 2**

| | Low-temperature Folding Test Result |
|---|---|
| Example 4 | 30,000 times OK |
| Example 5 | 1,000 times NG |
| Example 6 | 30,000 times OK |

Referring to Table 2, in Examples 4 and 6, no cracks occurred in the optical films in the folding test performed 30,000 times. On the other hand, in Example 5, cracks occurred in the optical film in the folding test performed 1,000 times.

Through such a result, it was confirmed that the occurrence of cracks in the optical film might be suppressed by disposing the folding axis to intersect a direction in which a crack strain of the optical film is about 2% or more.

In concluding the detailed description, those skilled in the art will appreciate that many variations and modifications can be made to the embodiments described herein without substantially departing from the present disclosure. Therefore, the disclosed embodiments of the present disclosure are used in a generic and descriptive sense and not for purposes of limitation.

## Claims

1. A display device (10) foldable about a folding axis, the display device comprising:
a display panel (100);
a cover window (CW) on the display panel (100); and
an optical film (OPF) on the cover window (CW), the optical film (OPF) having a machine direction (MD) and a transverse direction (TD),
wherein, the one of the machine direction (MD) and the transverse direction (TD) of the optical film (OPF) having a larger crack strain forms an angle in a range of 15° to 120° with the folding axis.

2. The display device of claim 1, wherein the crack strain of the optical film in the transverse direction is greater than the crack strain in the machine direction.

3. The display device of claim 2, wherein the angle between the transverse direction (TD) and the folding axis is 90°.

4. The display device of claim 1, wherein the crack strain of the optical film in the machine direction (MD) is greater than the crack strain in the transverse direction (TD), and
wherein the angle between the machine direction (MD) and the folding axis is 90°.

5. The display device of one of the preceding claims, wherein the optical film comprises:
a base layer (BFL);
a hard coating layer (HCL) on the base layer (BFL);
a low refraction layer (LRL) on the hard coating layer (HCL); and
an anti-fingerprint layer (AFL) on the low refraction layer (LRL).

6. The display device of claim 5, wherein the low refraction layer (LRL) comprises a resin and a plurality of particles dispersed in the resin.

7. The display device of one of claims 5 or 6, wherein a refractive index of the low refraction layer (LRL) is in a range of 1.3 to 1.48.

8. The display device of at least one of claims 5 to 7, wherein a thickness of the low refraction layer (LRL) is in a range of 10 nm to 200 nm.

9. The display device of at least one of claims 5 to 8, wherein a refractive index of the low refraction layer (LRL) is smaller than a refractive index of the hard coating layer.

10. The display device of at least one of claims 5 to 9, further comprising a primer layer between the low refraction layer (LRL) and the anti-fingerprint layer.

11. The display device of at least one of claims 5 to 10, further comprising a high refraction layer (HRL) between the low refraction layer (LRL) and the hard coating layer.

12. The display device of claim 11, wherein a refractive index of the high refraction layer (HRL) is in a range of 1.53 to 1.7.

13. The display device of at least one of claims 1 to 4, wherein the optical film comprises:
a base layer (BFL);
a hard coating layer (HCL) on the base layer (BFL); and
a composite layer (CPL) on the hard coating layer (HCL), the composite layer (CPL) comprising a resin and a plurality of particles and anti-fingerprint material dispersed in the resin.

14. The display device of claim 13, wherein the particles have a hollow, and wherein the anti-fingerprint material comprises a fluorine-based additive.

15. The display device of one of the preceding claims, wherein the one from among the machine direction (MD) and the transverse direction (TD) of the optical film (OPF) having a larger crack strain has a crack strain of 2% or more measured by nanoindentation.
